(19) Europäisches Patentamt / European Patent Office / Office européen des brevets

(11) **EP 4 208 726 B1**

(12) **EUROPÄISCHE PATENTSCHRIFT**

(45) Veröffentlichungstag und Bekanntmachung des Hinweises auf die Patenterteilung:
**21.08.2024 Patentblatt 2024/34**

(21) Anmeldenummer: **21770245.5**

(22) Anmeldetag: **03.09.2021**

(51) Internationale Patentklassifikation (IPC):
**G01R 31/62** $^{(2020.01)}$  **G01K 1/02** $^{(2021.01)}$
**G01K 7/42** $^{(2006.01)}$  **G01K 13/02** $^{(2021.01)}$

(52) Gemeinsame Patentklassifikation (CPC):
**G01R 31/62; G01K 1/026; G01K 7/42; G01K 13/026**

(86) Internationale Anmeldenummer:
**PCT/EP2021/074318**

(87) Internationale Veröffentlichungsnummer:
**WO 2022/069149 (07.04.2022 Gazette 2022/14)**

(54) **VORRICHTUNG UND SYSTEM ZUR INDIREKTEN TEMPERATURERMITTLUNG EINES LEISTUNGSTRANSFORMATORS**

DEVICE AND SYSTEM FOR INDIRECTLY DETERMINING THE TEMPERATURE OF A POWER TRANSFORMER

DISPOSITIF ET SYSTÈME POUR LA DÉTERMINATION INDIRECTE DE LA TEMPÉRATURE D'UN TRANSFORMATEUR DE PUISSANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.09.2020 DE 102020125533**

(43) Veröffentlichungstag der Anmeldung:
**12.07.2023 Patentblatt 2023/28**

(73) Patentinhaber: **Maschinenfabrik Reinhausen GmbH**
**93059 Regensburg (DE)**

(72) Erfinder:
• **ALBER, Alexander**
  **93047 Regensburg (DE)**
• **GRUBER, Tobias**
  **93128 Regenstauf (DE)**

(56) Entgegenhaltungen:
**WO-A1-2015/027127     CN-A- 106 844 972**

## Beschreibung

Leistungstransformatoren sind grundsätzlich aus dem Stand der Technik bekannt. Ein Leistungstransformator dient zur Transformation elektrischer Leistung von einer zugehörigen Primärseite an eine zugehörige Sekundärseite. Leistungstransformatoren sind oftmals dazu ausgebildet, um sehr hohe Leistungen zu transformieren. So kann ein Leistungstransformator beispielsweise mindestens 30 KW, mindestens 50 KW oder mindestens 100 KW transformieren. Durch die Transformation der elektrischen Leistung wird Wärme erzeugt, die über ein Kühlsystem des Leistungstransformators oftmals an die Umgebung abgegeben wird. Ein Leistungstransformator weist eine Primärseite mit einer Primärwicklung und eine Sekundärseite mit einer Sekundärwicklung auf. Der Leistungstransformator weist ein Gehäuse auf, das einen Tank bilden. Beide Wicklungen sind in dem Tank des Leistungstransformators angeordnet, wobei eine Kühlflüssigkeit, insbesondere Öl als Kühlflüssigkeit, in dem Tank vorhanden ist, und wobei der Tank über einen Fluidkreislauf mit einem Kühler des Kühlsystems verbunden ist. Die Kühlleistung des Kühlers hängt oftmals von der Umgebungstemperatur ab. Ist die Umgebungstemperatur niedrig, so kann eine hohe Temperaturdifferenz zwischen der Umgebungstemperatur und der Temperatur am Kühler zu einer guten Kühlleistung der Primär- und Sekundärseite beitragen. Steigt die Umgebungstemperatur, kann die Kühlleistung des Kühlers sinken. Um zu verhindern, dass die Kühlflüssigkeit überhitzt, sind Leistungstransformatoren oftmals mit Sensoren ausgestattet, um die Temperatur zumindest an einer Stelle des Leistungstransformators sensorisch zu erfassen.

Aus dem Stand der Technik sind außerdem mathematische Modelle bekannt, die zur Modellierung eines Leistungstransformators geeignet sind. Diese Modelle haben jedoch den Nachteil, dass eine Vielzahl von Parametern der Modelle vorbestimmt sein muss, damit die Modelle eine robuste Abbildung des tatsächlichen Leistungstransformators gewährleisten. Die Parameter der Modelle müssen oftmals basierend auf den tatsächlichen Eigenschaften des Leistungstransformators ermittelt werden. In der Praxis wurde festgestellt, dass ein nicht unerheblicher Aufwand notwendig ist, um derartige Parameter für die Modelle zu ermitteln. Diese Modelle werden in der Praxis deshalb nur sehr selten verwendet, um Eigenschaften eines Leistungstransformators zu modellieren.

In diesem Zusammenhang beschreibt WO 2015/027127 A1 ein Echtzeit-Wärmeüberwachungs- und Vorhersagesystem für die Überwachung und den Betrieb eines Transformators. Mittels eines dynamischen thermischen Modells für den Transformator und Umgebungstemperaturprognosen wird ein Belastungsniveau für den Transformator über einen zukünftigen Zeitraum abgeschätzt. Der Transformator kann bei einer Überlastung der Energieversorgung oder bei Wiederherstellung des Betriebs bis zu seinem maximalen Belastungsniveau belastet werden.

CN 106 844 972 A offenbart ein Verfahren zur Ermittlung der Temperatur von Transformatorwicklungen basierend auf einer Partikelschwarmoptimierung mit Support Vector Regression.

Der Erfindung liegt deshalb die Aufgabe zugrunde, eine Vorrichtung und/oder ein System mit einer derartigen Vorrichtung bereitzustellen, wobei mittels der Vorrichtung verlässlich und möglichst einfach auf eine relevante Temperatur des Leistungstransformators geschlossen werden können soll.

Gelöst wird die Aufgabe gemäß einem ersten Aspekt der Erfindung durch eine Vorrichtung mit den Merkmalen des Anspruchs 1. Vorgesehen ist also eine Vorrichtung, die eine Signalschnittstelle, eine Prozessoreinheit und eine Speichereinheit aufweist. Die Signalschnittstelle ist zum Empfang eines Messsignals ausgebildet, das erste Sensordaten und zweite Sensordaten repräsentiert, wobei die ersten und zweiten Sensordaten jeweils mindestens eine in oder an einem Leistungstransformator sensorisch erfasste Größe repräsentieren. Die Prozessoreinheit ist konfiguriert, in aufeinanderfolgenden Zeitfenstern jeweils einen Messdatensatz aus den im jeweiligen Zeitfenster empfangenen ersten und zweiten Sensordaten zu erzeugen. In der Speichereinheit ist ein Simulationsmodell des Leistungstransformators gespeichert, das ein Übertragungsverhalten von Eingangsdaten zu Ausgangsdaten in Abhängigkeit von Modellparametern des Simulationsmodells abbildet. Die Prozessoreinheit ist konfiguriert, für jedes Zeitfenster die folgende Gruppe von Schritten a) bis c) gruppenweise wiederholt auszuführen: a) Ermittlung von Ausgangsdaten durch Ausführen des Simulationsmodells mit Eingangsdaten, die von ersten Sensordaten des dem jeweiligen Zeitfenster zugeordneten Messdatensatzes bestimmt sind, und Modellparametern, die beim erstmaligen Ausführen des Simulationsmodells für das jeweilige Zeitfenster von vorbestimmten Referenzparametern und ansonsten von den jeweils zuletzt ermittelten Optimierungsparametern bestimmt sind, b) Ermittlung eines Zielwerts, der zumindest einen mit einem ersten Gewichtungsfaktor gewichteten, quadratischen Fehler zwischen den zweiten Sensordaten des dem jeweiligen Zeitfenster zugeordneten Messdatensatzes und den zuvor ermittelten Ausgangsdaten umfasst, und c) Ermittlung von Optimierungsparametern als neue Modellparameter für das Simulationsmodell basierend auf dem mindestens einen im jeweiligen Zeitfenster ermittelten Zielwert. Das Simulationsmodell bildet außerdem einen Modellwert für eine Temperatur innerhalb des Leistungstransformators in Abhängigkeit von Eingangsdaten und Modellparametern ab. Die Prozessoreinheit ist konfiguriert, für jedes Zeitfenster den Modellwert durch Ausführen des Simulationsmodells mit Eingangsdaten, die von ersten Sensordaten des dem jeweiligen Zeitfenster zugeordneten Messdatensatzes bestimmt sind, und Modellparametern, die für das jeweilige Zeitfenster von den jeweils zuletzt ermittelten Optimierungsparametern bestimmt sind, zu ermitteln.

Bevor im Weiteren detailliert auf die Merkmale der Vorrichtung gemäß dem ersten Aspekt eingegangen wird, ist hervorzuheben, dass es mit der Vorrichtung und insbesondere mit der Prozessoreinheit der Vorrichtung möglich ist, die Modellparameter für das Simulationsmodell von Zeitfenster zu Zeitfenster zu verbessern, sodass mittels des Simulationsmodells ein Modellwert für eine Temperatur innerhalb des Leistungstransformators ermittelt werden kann, die zuvor nicht sensorisch an oder in dem Leistungstransformator erfasst wurde. Dadurch kann der thermische Zustand des Leistungstransformators besonders sicher überwacht werden. Die wiederholte Optimierung der Modellparameter des Simulationsmodells erlaubt außerdem eine besonders einfache Inbetriebnahme der Vorrichtung. Denn die Modellparameter, die beim erstmaligen Ausführen des Simulationsmodells verwendet werden, sollten zwar eine gute Abschätzung für die Modellparameter sein, müssen jedoch nicht zwingend optimal sein. Sie können deshalb beim Start durch vorbestimmte Referenzparameter bestimmt sein. Nachdem die Modellparameter für das Simulationsmodell nach mehreren Zeitfenstern verbessert sind, kann mindestens eine Temperatur mittels des Simulationsmodells innerhalb des Leistungstransformators von der Prozessoreinheit ermittelt werden, und diese ermittelte Temperatur kann zur Überwachung des Leistungstransformators verwendet werden. Dies erlaubt eine bessere Ausnutzung der Leistungsfähigkeit des Transformators, und zwar auch an der thermischen Leistungsgrenze.

Im Folgenden soll auf Merkmale der Vorrichtung detaillierter eingegangen werden.

Die Vorrichtung weist die Signalschnittstelle, die Prozessoreinheit und die Speichereinheit auf. Die Signalschnittstelle kann eine leitungsgebundene Signalschnittstelle oder eine Funk-Signalschnittstelle sein. Die Signalschnittstelle ist zum Empfang des Messsignals ausgebildet, das die ersten Sensordaten und die zweiten Sensordaten repräsentiert. Die Vorrichtung kann eine weitere Signalschnittstelle aufweisen, die zum Senden eines Ausgangssignals ausgebildet ist, das den von der Prozessoreinheit ermittelten Modellwert für die Temperatur repräsentiert. Grundsätzlich ist es möglich, dass die Signalschnittstelle zum Empfang des Messsignals und die weitere Signalschnittstelle zum Senden des Ausgangssignals von einer gemeinsamen Signalschnittstelle gebildet sind. Sie können jedoch auch als getrennte Signalschnittstellen ausgebildet sein.

Die ersten Sensordaten und die zweiten Sensordaten repräsentieren jeweils mindestens eine in oder an dem Leistungstransformator sensorisch erfasste Größe. Hierbei handelt es sich vorzugsweise um eine mit einem Sensor erfasste Größe. Die jeweils sensorisch erfasste Größe bezieht sich vorzugsweise auf eine mechanische, elektrische oder andere physikalische Größe. Die ersten Sensordaten repräsentieren vorzugsweise sensorisch erfassbare und exogene Größen des Leistungstransformators. Die zweiten Sensordaten repräsentieren vorzugsweise sensorisch erfassbare jedoch nicht-exogene Größen des Leistungstransformators. Die ersten Sensordaten können also sensorisch erfassbare Größen des Leistungstransformators repräsentieren, die von außen auf den Leistungstransformator und/oder nicht beeinflussbar auf den Leistungstransformator wirken. Diese können beispielsweise die an den Anschlüssen der Primärseite des Leistungstransformators anliegende Spannung, der durch die Windungen der Primärseite fließende Strom oder die Umgebungstemperatur des Leistungstransformators sein. Durch die exogenen Größen des Leistungstransformators werden nicht-exogene Größen des Leistungstransformators, wie beispielsweise die Temperatur der Kühlflüssigkeit innerhalb des Tanks des Leistungstransformators, beeinflusst. Bei den von den zweiten Sensordaten repräsentierten Größen handelt es sich also vorzugsweise um Größen des Leistungstransformators, die durch die Größen verursacht sind, die von den ersten Sensordaten repräsentiert sind.

Die von den ersten und zweiten Sensordaten repräsentierten Größen des Leistungstransformators werden vorzugsweise mit einer vorbestimmten Frequenz abgetastet, sodass das Messsignal vorzugsweise einen kontinuierlichen Datenstrom der Abtastwerte in Form der ersten Sensordaten und zweiten Sensordaten repräsentiert. Die Prozessoreinheit ist deshalb dazu konfiguriert, in aufeinanderfolgenden Zeitfenstern jeweils einen Messdatensatz aus den im jeweiligen Zeitfenster empfangenen ersten und zweiten Sensordaten zu erzeugen. Wird also mittels des Messsignals ein kontinuierlicher Datenstrom der ersten und zweiten Sensordaten über die Signalschnittstelle an die Prozessoreinheit geleitet, so wird die Prozessoreinheit aus diesem Datenstrom über ein jeweiliges Zeitfenster erste und zweite Sensordaten aus dem Datenstrom kopieren, um ein dem jeweiligen Zeitfenster zugeordneten Messdatensatz zu erzeugen. Die Zeitfenster können sich teilweise zeitlich überlappen. Hat ein Zeitfenster beispielsweise eine zeitliche Dauer von 24 Stunden und wird alle vier Stunden für ein neues Zeitfenster der zurückliegenden 24 Stunden jeweils ein zugehöriger Messdatensatz von der Prozessoreinheit erzeugt, so überlappen sich die aufeinanderfolgenden Zeitfenster zumindest teilweise, was in entsprechender Weise auch für die Messdatensätze gilt. In dem vorangegangenen Beispiel können sich beispielsweise ein zuletzt festgelegtes Zeitfenster und ein zuvor festgelegtes Zeitfenster über eine Zeitdauer von sechszehn Stunden überlappen. Jedes Zeitfenster kann eine Überlappung zu mehreren vorherigen Zeitfenstern aufweisen. Sofern sich die Zeitfenster überlappen, ist es bevorzugt vorgesehen, dass aus dem Datenstrom Daten kopiert werden, um den für das jeweilige Zeitfenster zugehörigen Messdatensatz zu erzeugen. Hierzu kann die Prozessoreinheit entsprechend konfiguriert sein. Grundsätzlich ist es jedoch auch möglich, dass die Zeitfenster unmittelbar und überlappungsfrei aufeinander folgen. Die Zeitfenster können also ohne Überlappung festgelegt sein. Es ist aber auch möglich, dass zwischen den Zeitfenstern jeweils eine bestimmte oder beliebige zeitliche Pause vorgesehen ist, in der keine der über das Messsignal empfangenen Daten zur Erzeugung des Messdatensatzes verwendet werden. Jedes Zeitfenster weist vorzugsweise eine vorbestimmte, konstante zeitliche Größe auf. Werden eine Vielzahl von Messdatensätze für die jeweils zugehörigen Zeitfenster erzeugt, wird auch davon gesprochen, dass sich die Zeitfenster in diskreten, vorbestimmten Abständen zeitlich vorwärts bewegen und zu jedem Zeitfenster ein zugehöriger Messdatensatz mittels der Prozessoreinheit erzeugt wird. Wie zuvor bereits erläutert, ist es bevorzugt vorgesehen, dass die Dauer jedes Zeitfensters beispielsweise 24 Stunden beträgt. Außerdem kann das Zeitfenster alle vier Stunden um jeweils vier Stunden vorwärts bewegt werden. Tatsächlich handelt es sich dabei jedoch nicht um das gleiche Zeitfenster, sondern es wird ein neues Zeitfenster der gleichen Größe festgelegt.

In der Speichereinheit der Vorrichtung ist ein Simulationsmodell gespeichert. Das Simulationsmodell ist vorzugsweise ein von der Prozessoreinheit ausführbares, mathematisches Modell des Leistungstransformators, wobei das Simulationsmodell ein Übertragungsverhalten von Eingangsdaten zu Ausgangsdaten in Abhängigkeit von Modellparametern des Simulationsmodells abbildet. Die Eingangsdaten können von Daten gebildet sein, die sensorisch erfassbare, exogene Größen des Leistungstransformators repräsentieren. Die Ausgangsdaten können von Daten gebildet sein, die Größen des Leistungstransformators repräsentieren, die nicht sensorisch erfassbar sind und/oder die nicht-exogene Größen des Leistungstransformators repräsentieren. Das Simulationsmodell bildet vorzugsweise auch ein Übertragungsverhalten von Eingangsdaten zu dem Modellwert in Abhängigkeit von Modellparametern des Simulationsmodells ab.

Das Simulationsmodell bietet den Vorteil, dass das Simulationsmodell mittels der Prozessoreinheit dazu genutzt werden kann, um mindestens einen oder mehrere Zustände des Leistungstransformators zu schätzen. Ein Zustand des Leistungstransformators kann beispielsweise eine innerhalb des Leistungstransformators bestehende Temperatur sein, oder andere physikalische Größen des Leistungstransformators sein, die von exogenen Größen des Leistungstransformators abhängen. Die Ausgangsdaten, die bei einer Simulation mittels des Simulationsmodells entstehen können, betreffen deshalb oftmals ähnliche oder gleiche Transformatoreigenschaften, wie die zweiten Sensordaten, die von dem Messsignal repräsentiert werden und über das Messsignal an die Prozessoreinheit gelangen. Die Ausgangsdaten, die bei der Simulation mittels des Simulationsmodells entstehen, sind dabei jedoch vorzugsweise als Schätzwerte für die Transformatoreigenschaften zu verstehen, wohingegen die sensorisch erfassten, zweiten Sensordaten vorzugsweise als Ist-Werte für die entsprechenden Transformatoreigenschaften zu verstehen sind. Mit anderen Worten können die Ausgangsdaten Schätzwerte für die Transformatoreigenschaften repräsentieren und die zweiten Sensordaten können sensorisch erfasste Ist-Werte für die gleichen Sensoreigenschaften repräsentieren. Über die Ausgangsdaten und die zweiten Sensordaten ist deshalb ein Abgleich zwischen den Schätzwerten und Ist-Werten möglich, wobei das Ergebnis des Abgleichs einen Fehler der Schätzwerte gegenüber den Ist-Werten, oder umgekehrt, repräsentiert. Ist der Fehler klein, so ist davon auszugehen, dass das Simulationsmodell den Leistungstransformator besonders gut abbildet. Um eine Verringerung des Fehlers zu erzielen, werden vorzugsweise für jedes Zeitfenster die oben genannte Gruppe (Schritte a), b) und c)) gruppenweise wiederholt ausgeführt, um eine Optimierung der Modellparameter des Simulationsmodells zu erreichen. Ziel ist es dabei, dass der gewichtete, quadratische Fehler zwischen den zweiten Sensordaten des dem jeweiligen Zeitfenster zugeordneten Messdatensatzes und den Ausgangsdaten, die durch die Simulation bei der Ausführung von Schritt a) in der entsprechenden Gruppe von Schritten a) bis c) erzeugt worden sind, zu minimieren. Dadurch können in Schritt c) jeweils Optimierungsparameter als neue Modellparameter für das Simulationsmodell mittels der Prozessoreinheit ermittelt werden, sodass die Modellparameter nach einer vielfachen Ausführung der Gruppe von Schritten a) bis c) derart verbessert sind, dass sich der gewichtete, quadratische Fehler oftmals auf ein Minimum reduziert. Vorzugsweise wird die Gruppe von Schritten a) bis c) für mindestens 100 Zeitfenster wiederholt. Die Gruppe von Schritten a) bis c) wird dabei für jedes Zeitfenster wiederholt ausgeführt. Es findet also die genannte gruppenweise Wiederholung statt.

Das Simulationsmodell ist außerdem dazu ausgebildet, einen Modellwert für eine Temperatur innerhalb des Leistungstransformators in Abhängigkeit der Eingangsdaten und der Modellparameter, insbesondere der zuletzt durch die jeweiligen Optimierungsparameter aktualisierten Modellparameter, bei der Ausführung des Simulationsmodells zu erzeugen. Der Modellwert repräsentiert vorzugsweise eine Temperatur an einer vorbestimmten Stelle innerhalb des Leistungstransformators. Diese Stelle kann eine beliebige, vorbestimmte Stelle innerhalb des Leistungstransformators sein. So kann sich die Temperatur beispielsweise auf die Hotspot-Temperatur an einer der Windungen der Primärseite oder Sekundärseite beziehen. Der Modellwert kann sich jedoch auch auf eine sogenannte Top-Oil-Temperatur beziehen. Dies ist insbesondere dann der Fall, wenn die Kühlflüssigkeit von Öl gebildet ist, die im Tank des Leistungstransformators ist. Vorzugsweise ist die Top-Oil-Temperatur im oberen Bereich des Tanks.

Um eine möglichst genaue Aktualisierung des Modellwerts zu erreichen, ist es vorgesehen, dass die Prozessoreinheit den Modellwert für jedes Zeitfenster durch Ausführen des Simulationsmodells ermittelt. Dabei wird das Simulationsmodell mit Eingangsdaten, die von ersten Sensordaten des dem jeweiligen Zeitfenster zugeordneten Messdatensatzes bestimmt sind, und Modellparametern, die für das jeweilige Zeitfenster von den zuletzt ermittelten Optimierungsparametern bestimmt sind, ausgeführt. Hierzu kann die Prozessoreinheit entsprechend konfiguriert sein. Zu jedem Zeitfenster kann deshalb durch die Prozessoreinheit ein Modellwert für eine der zuvor genannten Temperaturen innerhalb des Leistungstransformators ermittelt werden. Diese Temperatur kann anschließend von einem Ausgangssignal repräsentiert sein, das durch die oder eine weitere Signalschnittstelle der Vorrichtung übertragen, insbesondere gesendet, werden kann. Dem Empfänger stehen deshalb die Informationen über die zuvor genannte Temperatur innerhalb des Leistungstransformators in einer ausreichenden Aktualisierungsrate zur Verfügung.

In dem von der Prozessoreinheit ausführbaren Schritt b) erfolgt eine Ermittlung eines Zielwerts. Der Zielwert kann aus der Summe von mehreren Komponenten gebildet sein. Es ist jedoch vorgesehen, dass der Zielwert zumindest den folgenden, gewichteten quadratischen Fehler als eine Komponente umfasst oder sogar allein davon gebildet ist. So ist es beispielsweise vorgesehen, dass der Zielwert den mit dem ersten Gewichtungsfaktor gewichteten, quadratischen Fehler zwischen den zweiten Sensordaten des dem jeweiligen Zeitfenster zugeordneten Messdatensatzes und den zuvor ermittelten Ausgangsdaten umfasst oder allein davon gebildet ist. Der einfache (nicht quadratische) Fehler kann beispielsweise durch die Differenz zwischen den zweiten Sensordaten und den Ausgangsdaten gebildet sein. Vorzugsweise ist die Prozessoreinheit zur Ermittlung dieses Fehlers ausgebildet. Die zweiten Sensordaten und die Ausgangsdaten können jeweils als ein Datenvektor verstanden werden, wobei der einfache Fehler aus der Differenz der beiden Vektoren gebildet sein kann. Der quadratische Fehler kann wiederum der Summe der quadrierten Einträge des einfachen Fehlers gebildet sein. Hierzu kann die Prozessoreinheit ausgebildet sein. Der quadratische Fehler ist deshalb vorzugsweise eine eindimensionale Größe.

Die Prozessoreinheit ist vorzugsweise dazu konfiguriert, ein vorbestimmtes Optimierungsverfahren auszuführen, um die Optimierungsparameter in Schritt c) zu ermitteln. So kann die Prozessoreinheit beispielsweise dazu konfiguriert sein, die Gruppe, die die Schritte a) bis c) umfasst, derart oft zu wiederholen, bis in Schritt b) ein Zielwert erreicht ist, der kleiner als ein vorbestimmter Grenzwert ist und/oder wenn in Schritt b) oder c) ein vorbestimmtes Abbruchkriterium erfüllt ist. So ist es beispielsweise möglich, dass die Prozessoreinheit konfiguriert ist, für die Schritte a) bis c) ein sogenanntes SQP (sequential quadratic programming) Optimierungsverfahren oder ein Active-Set-Verfahren auszuführen, um das SQP-Problem zu lösen. So kann die Prozessoreinheit dazu konfiguriert sein, in Schritt c) die Optimierungsparameter in Abhängigkeit des zuletzt ermittelten Zielwert in Schritt b) oder in Abhängigkeit von mehreren Zielwerten aus mehreren, vorangegangenen Schritten b) zu ermitteln. Wenn mehrere Zielwerte aus vorherigen Schritten b) berücksichtigt werden, ist es dabei bevorzugt, dass diese Schritte zu dem gleichen Zeitfenster ausgeführt worden sind. In Schritt c) kann die Prozessoreinheit also Optimierungsparameter in der Abhängigkeit von einen oder mehreren Zielwerten ermitteln, sodass bei der erneuten Ausführung von Schritt b) ein kleinerer Zielwert ermittelt wird. Dieser Ablauf der Optimierung kann mehrfach wiederholt werden, bis in Schritt b) ein besonders kleiner Zielwert und in Schritt c) Optimierungsparameter bzw. neue Modellparameter für das neue Simulationsmodell ermittelt werden, sodass mittels des Simulationsmodells eine besonders gute und exakte Abbildung des Leistungstransformators möglich ist.

Eine vorteilhafte Ausgestaltung der Vorrichtung zeichnet sich dadurch aus, dass die von dem Modellwert abgebildete Temperatur des Leistungstransformators eine Hot-Spot-Temperatur oder eine Top-Oil-Temperatur oder eine Bottom-Oil-Temperatur des Leistungstransformators umfasst oder ist. Die Hot-Spot-Temperatur, die Top-Oil-Temperatur und die Bottom-Oil-Temperatur sind oftmals besonders interessante und relevante Temperaturen für den Betrieb eines Leistungstransformators. Nicht immer werden diese Temperaturen sensorisch erfasst. Das Simulationsmodell bietet deshalb die Möglichkeit, dass die Prozessoreinheit den Modellwert mittels des Simulationsmodells ermittelt, wobei der Modellwert mindestens eine der genannten Temperaturen oder mehrere der genannten Temperaturen des Leistungstransformators abbildet und damit repräsentiert. Mittels des Simulationsmodells kann deshalb eine Vielzahl von Temperaturen und/oder die besonders relevante Temperaturen ermittelt werden, die nicht notwendigerweise mittels eines Sensors erfasst sind und/oder sein müssen.

Eine weitere vorteilhafte Ausgestaltung der Vorrichtung zeichnet sich dadurch aus, dass sich die Temperatur im Leistungstransformator, die von dem Modellwert abgebildet werden kann, auf eine Temperatur in einem Bereich an der oberen Schicht des Öls im Leistungstransformator oder auf eine Temperatur an einer Stelle an einer der Windungen des Leistungstransformators bezieht. Insbesondere eine Temperatur direkt an einer Windung des Leistungstransformators ist nur mit höherem Aufwand sensorisch zu erfassen. Dieser Aufwand kann durch die Verwendung des Simulationsmodells verringert werden. Denn für die Optimierung der Modellparameter des Simulationsmodells können die zweiten Sensordaten und die Ausgangsdaten verwendet werden, wobei die zweiten Sensordaten sensorisch erfasste Größen des Leistungstransformators repräsentieren. Diese von den zweiten Sensordaten repräsentierten Größen können beispielsweise einfach oder mit wenig Aufwand sensorisch erfassbare Größen des Leistungstransformators sein. Deshalb ist es möglich, dass die Ermittlung einer Temperatur an einer vorbestimmten Stelle im Leistungstransformator mit einem verringerten Aufwand möglich ist.

Weiterhin kann es vorteilhaft vorgesehen sein, dass mindestens ein weiterer Modellwert vorgesehen ist, der jeweils eine weitere physikalische Größe des Leistungstransformators in Abhängigkeit von Eingangsdaten und Modellparametern abbildet. Die Prozessoreinheit kann außerdem konfiguriert sein, für jedes Zeitfenster jeden der Modellwerte durch Ausführen des Simulationsmodells mit Eingangsdaten und Modellparametern zu ermitteln. Ein weiterer Modellwert kann beispielsweise einen Strom, eine Spannung, eine mechanische Kraft oder andere physikalische Größe des Leistungstransformators abbilden. Wenn im Folgenden auf den Modellwert für die Temperatur innerhalb des Leistungstransformators Bezug genommen wird, so ist es bevorzugt vorgesehen, dass die zugehörigen, bevorzugten Erläuterungen, vorteilhaften Merkmale, technischen Effekte und Vorteile in analoger Weise für jeden weiteren Modellwert in analoger Weise gelten können.

Eine weitere vorteilhafte Ausgestaltung der Vorrichtung zeichnet sich dadurch aus, dass die Anzahl der gruppenweisen Wiederholung der Gruppe der Schritte a) bis c) zwischen 10 und 1000 ist. Die gruppenweise Wiederholung bezieht sich dabei auf die Wiederholung der gesamten Gruppe mit den Schritten a) bis c). Es wird also jeweils die Gruppe der Schritte a) bis c) ausgeführt, um im Anschluss die Wiederholung zu beginnen, und zwar wieder mit Schritt a) bis c). Die Gruppe der Schritte wird also gruppenweise wiederholt. Durch die Mindestanzahl von zehn Wiederholungen und die Begrenzung der Anzahl auf 1000 Wiederholungen ist ein vorteilhafter Bereich für die Anzahl der Wiederholungen angegeben, bei dem es sich in der Praxis gezeigt hat, dass damit Modellparameter für das Simulationsmodell ermittelt werden können, sodass der Leistungstransformator durch das Simulationsmodell und den zugehörigen Modellparametern besonders gut abgebildet werden kann.

Eine weitere vorteilhafte Ausgestaltung der Vorrichtung zeichnet sich dadurch aus, dass die Vorrichtung konfiguriert ist, den Zielwert in Schritt b) ab der Ausführung für das zweite Zeitfenster jeweils derart zu ermitteln, so dass der Zielwert außerdem eine mit einem zweiten Gewichtungsfaktor gewichtete, quadratische Differenz zwischen den zuletzt bestimmten Modellparametern und den als letztes für das vorherige Zeitfenster ermittelten Optimierungsparametern umfasst. Wie bereits eingangs erläutert worden ist, ist die Prozessoreinheit konfiguriert, in aufeinanderfolgenden Zeitfenstern jeweils einen Messdatensatz aus den im jeweiligen Zeitfenster empfangenen ersten und zweiten Sensordaten zu erzeugen. Das zweite Zeitfenster ist somit das zweite Zeitfenster in der Reihenfolge der Zeitfenster. Die Gruppe mit den Schritten a), b) und c) wird von der Prozessoreinheit der Vorrichtung für jedes Zeitfenster mehrfach nacheinander ausgeführt, wobei innerhalb jeder Gruppe der Schritt b) auf den Schritt a) folgt und auf den Schritt b) der Schritt c) folgt. In jedem Schritt c) ermittelt die Prozessoreinheit Optimierungsparameter als neue Modellparameter für das Simulationsmodell.

Für jedes Zeitfenster wird der Schritt c) aufgrund der Wiederholung der Gruppe ebenfalls mehrfach ausgeführt. Es gibt deshalb auch ein letztes Ausführen des Schritts c), so dass für das jeweilige Zeitfenster beim letztmaligen Ausführen des Schritts c) auch die zuletzt bestimmten Optimierungsparameter als neue Modellparameter für das Simulationsmodell und in Bezug auf das jeweilige Signalfenster festgelegt werden.

In Schritt b) der Gruppe Schritt a) bis c) wird ein Zielwert ermittelt, der gemäß dem ersten Aspekt der Erfindung zumindest einen mit einem ersten Gewichtungsfaktor gewichteten, quadratischen Fehler zwischen den zweiten Sensordaten des dem jeweiligen Zeitfenster zugeordneten Messdatensatzes und den zuvor ermittelten Ausgangsdaten umfasst. Gemäß der zuletzt genannten, vorteilhaften Ausgestaltung der Vorrichtung ist es bevorzugt vorgesehen, dass der Zielwert außerdem eine mit einem zweiten Gewichtungsfaktor gewichtete, quadratische Differenz zwischen den zuletzt bestimmten Modellparametern und den als letztes für das vorherige Zeitfenster ermittelten Optimierungsparametern umfasst. Bei der Wiederholung der Gruppe der Schritte a) bis c) für und ab dem zweiten Zielfenster wird also jeweils ein Zielwert ermittelt, der aus mindestens zwei Komponenten, nämlich dem gewichteten, quadratischen Fehler und der gewichteten, quadratischen Differenz gebildet ist. Durch den ersten und zweiten Gewichtungsfaktor wird festgelegt, welche der beiden Komponenten den Zielwert zum größeren Anteil festlegt. Als vorteilhaft hat es sich herausgestellt, wenn der zweite Gewichtungsfaktor größer als der erste Gewichtungsfaktor ist. In diesem Fall wird der Zielwert durch die quadratische Differenz stärker beeinflusst. Ein größerer, zweiter Gewichtungsfaktor verhindert einen schnellen Wechsel der Modellparameter. Denn die quadratische Differenz beruht zunächst einmal auf der einfachen Differenz der jeweils zuletzt bestimmten Modellparametern und den als letztes für das vorherige Zeitfenster ermittelten Optimierungsparametern. Um den Zielwert in Schritt b) bei der Ausführung für das zweite Zeitfenster zu ermitteln, kann beispielsweise mittels der Prozessoreinheit zunächst die einfache Differenz zwischen den Modellparametern, die zuletzt bestimmt worden sind, und den als letztes für das erste Zeitfenster ermittelten Optimierungsparametern bestimmt werden. Die Modellparameter und die Optimierungsparameter können jeweils als Vektor aufgefasst werden, so kann die einfache Differenz zwischen den Modellparametern und den Optimierungsparametern ebenfalls als ein Vektor verstanden werden. Die quadratische Differenz ist dabei die Summe der quadratischen Einträge des als Vektors verstandenen einfachen Differenz. Die quadratische Differenz ist somit ein eindimensionaler Wert. Die Prozessoreinheit kann konfiguriert sein, die einfache und/oder quadratische Differenz zu ermitteln. Der Zielwert kann durch die Summe aus dem mit dem ersten Gewichtungsfaktor gewichteten, Fehler und der mit dem zweiten Gewichtungsfaktor gewichteten, quadratischen Differenz bestimmt sein. Die Prozessoreinheit kann vorzugsweise dazu ausgebildet sein, den Zielwert entsprechend zu ermitteln.

Eine weitere vorteilhafte Ausgestaltung der Vorrichtung zeichnet sich dadurch aus, dass die Vorrichtung konfiguriert ist, den Zielwert in Schritt b) derart zu ermitteln, so dass der Zielwert außerdem eine mit einem dritten Gewichtungsfaktor gewichtete, quadratische Differenz zwischen den zuletzt bestimmten Modellparametern und Referenzparametern umfasst. Der Zielwert kann somit beispielsweise aus der Summe von drei Komponenten gebildet sein. Die erste Komponente kann von dem mit dem ersten Gewichtungsfaktor gewichteten, quadratischen Fehler, die zweite Komponenten von der mit dem zweiten Gewichtungsfaktor gewichteten, quadratischen Differenz und die dritte Komponenten von der mit dem dritten Gewichtungsfaktor gewichteten, quadratischen Differenz gebildet sein. Die mit dem zweiten und dritten Gewichtungsfaktor gewichtete, quadratische Differenz ist jeweils unterschiedlich. Die zu dem zweiten Gewichtungsfaktor zugehörige, quadratische Differenz bezieht sich auf die quadratische Differenz, wie sie zu dem vorhergehenden, vorteilhaften Ausführungsbeispiel erläutert wurde. Die quadratische Differenz, die mit dem direkten Gewichtungsfaktor gewichtet wird, bezieht sich auf die quadratische Differenz zwischen den zuletzt bestimmten Modellparametern und Referenzparametern. Für die Bestimmung der Differenz wird auf die vorteilhaften Erläuterungen, bevorzugten Merkmale und Effekte in analoger Weise Bezug genommen, wie sie zu der vorherigen Differenz erläutert worden sind.

Die Referenzparameter können vorbestimmt sein. Sie können beispielsweise als Startwerte für die Modellparameter vorbestimmt sein. Diese Startwerte können von einem Benutzer der Vorrichtung vorbestimmt und/oder in der Speichereinheit der Vorrichtung abgespeichert sein. Die Dimension der Referenzparameter entspricht vorzugsweise der Dimension der Modellparameter. Werden die Modellparameter und die Referenzparameter jeweils als Vektor verstanden, so kann die einfache Differenz zwischen den Modellparametern und den Referenzparametern ebenfalls einen Vektor ergeben. Die einfache Differenz zwischen den zuletzt bestimmten Modellparametern und den Referenzparametern kann somit ein Vektor aus Differenzgrößen sein. Die quadratische Differenz der einfachen Differenz ist vorzugsweise die Summe der quadratischen Einträge der einfachen Differenz bzw. des zugehörigen Vektors. Die Prozessoreinheit ist vorzugsweise dazu konfiguriert, die einfache und/oder quadratische Differenz zu ermitteln. Der dritte Gewichtungsfaktor wird in Bezug auf den ersten und zweiten Gewichtungsfaktor oftmals klein gewählt und führt dadurch zu einer schwachen Gewichtung. Damit wird beim Optimieren der Modellparameter positiv darauf eingewirkt, Modellparameter vorzugsweise nur soweit anzupassen, wie es zum Vorteil entsprechend des Zielwerts ist. Langsame Abweichungen, die auch als Drifts bezeichnet werden können, durch irrelevante oder redundante Modellparameter können mithilfe des dritten Gewichtungsfaktors vermieden werden.

Eine weitere vorteilhafte Ausgestaltung der Vorrichtung zeichnet sich dadurch aus, dass die ersten Sensordaten von außen auf den Leistungstransformator wirkende und sensorisch erfasste Größen repräsentieren. Eine dieser Größen ist beispielsweise die Umgebungstemperatur, die von außen auf den Leistungstransformator wirkt. Die Umgebungstemperatur kann somit von den ersten Sensordaten repräsentiert sein. Die Umgebungstemperatur hat Einfluss auf die Eigenschaften innerhalb des Transformators. So kann die Temperatur der Kühlflüssigkeit, insbesondere Öl, innerhalb des Transformators von der Außentemperatur beeinflusst sein. Die Temperatur der Kühlflüssigkeit in dem Leistungstransformator kann außerdem von der Leistung der Sonneneinstrahlung abhängen, die von außen auf den Leistungstransformator wirkt. Eine entsprechende Sonneneinstrahlungsleistung kann deshalb als eine von außen auf den Leistungstransformator wirkende und sensorisch erfassbare Größe durch die ersten Sensordaten repräsentiert sein. Die Umgebungstemperatur und die Sonneneinstrahlungsleistung sind jeweils Größen, die nicht von dem Zustand des Leistungstransformators beeinflusst sind. Andere von außen auf den Leistungstransformator wirkende Größen sind beispielsweise ein elektrischer Strom, eine elektrische Spannung oder eine elektrische Leistung an der Primärseite oder an der Sekundärseite des Leistungstransformators. Alle der zuvor genannten Größen wirken von außen auf den Leistungstransformator und verursachen eine Veränderung von physikalischen Größen innerhalb des Leistungstransformators. Die ersten Sensordaten repräsentieren vorzugsweise ausschließlich die von außen auf den Leistungstransformator wirkende und sensorisch erfasste Größen. Sofern die Modellparameter derart gewählt sind, dass das Simulationsmodell das Verhalten des Leistungstransformators korrekt abbildet, können mit den ersten Sensordaten als Eingangsdaten neue Ausgangsdaten erzeugt werden, die physikalische Größen innerhalb des Leistungstransformators repräsentieren und die gegebenenfalls nicht sensorisch erfasst sind oder nicht sensorisch erfasst werden können, zumindest mit angemessenem Aufwand.

Eine weitere vorteilhafte Ausgestaltung der Vorrichtung zeichnet sich dadurch aus, dass die ersten Sensordaten mindestens zwei Größen der folgenden Gruppe von Größen repräsentieren: elektrischer Strom an der Primärseite des Leistungstransformators, elektrischer Strom an der Sekundärseite des Leistungstransformators, elektrische Leistung an der Primärseite des Leistungstransformators, elektrische Leistung an der Sekundärseite des Leistungstransformators, Umgebungstemperatur an der Außenseite des Leistungstransformators, Sonnenstrahlungsleistung an der Außenseite des Leistungstransformators und Windgeschwindigkeit an der Außenseite des Leistungstransformtors. Die zuvor genannte Gruppe von möglichen physikalischen Größen, die von außen auf den Leistungstransformator wirken und sensorisch erfassbar sind, kann eine geschlossene oder offene Gruppe sein. So ist es möglich, dass die Sensordaten ausschließlich mindestens zwei Größen der genannten Gruppe repräsentieren. Die Größen der zuvor genannten Gruppe haben vorzugsweise gemeinsam, dass sie von außen auf den Leistungstransformator wirken und dadurch eine Veränderung von physikalischen Größen innerhalb des Leistungstransformators verursachen.

Eine weitere vorteilhafte Ausgestaltung der Vorrichtung zeichnet sich dadurch aus, dass die zweiten Sensordaten im Inneren des Leistungstransformators erfasste Größen repräsentieren. Diese erfassten Größen beziehen sich vorzugsweise auf physikalische Größen von Bestandteilen des Leistungstransformators, die innerhalb des Leistungstransformators, insbesondere innerhalb des Gehäuses des Leistungstransformators, angeordnet sind. Es können sich beispielsweise um physikalische Größen der Kühlflüssigkeit, insbesondere Öl, physikalische Größen der Windungen an der Primär- und/oder Sekundärseite, und/oder mechanische Größen handeln, die durch mechanische Wechselwirkung zwischen Bauteilen innerhalb des Leistungstransformators auftreten. Die von den zweiten Sensordaten repräsentierten Größen sind deshalb vorzugsweise eine Folge der Einwirkung der von den ersten Sensordaten repräsentierten Größen auf den Leistungstransformator und dem Systemverhalten des Leistungstransformators als solches. Wird beispielsweise die Außentemperatur von den ersten Sensordaten repräsentiert, so kann die Außentemperatur auf den Leistungstransformator einwirken und dessen Systemverhalten zu einer Veränderung der Temperatur des Öls, das beispielsweise die Kühlflüssigkeit bildet, führen. Die Öltemperatur kann somit von den zweiten Sensordaten repräsentiert sein, da diese eine resultierende, innerhalb des Leistungstransformators auftretende Größe ist. Die von den zweiten Sensordaten repräsentierten Größen sind sensorisch erfassbar. Dies gilt auch für das zuvor genannte Beispiel, bei dem die Öltemperatur von den zweiten Sensordaten repräsentiert ist.

Eine weitere vorteilhafte Ausgestaltung der Vorrichtung zeichnet sich dadurch aus, dass die zweiten Sensordaten mindestens eine Größe der folgenden Gruppe von Größen repräsentieren: Öltemperatur, Öltemperatur an der Oberseite des Leistungstransformators, Öltemperatur an der Unterseite des Leistungstransformators, Windungstemperatur an Windungen der Primärseite, Windungstemperatur an Windungen der Sekundärseite, Wärmestrom von Windungen der Primärseite des Leistungstransformators ins Öl des Leistungstransformators, Wärmestrom von Windungen der Sekundärseite des Leistungstransformators ins Öl des Leistungstransformators, und Ölviskosität des Öls des Leistungstransformators. Die zuvor genannte Gruppe von möglichen physikalischen Größen kann eine geschlossene oder offene Gruppe sein. So ist es möglich, dass die zweiten Sensordaten ausschließlich mindestens zwei Größen der genannten Gruppe repräsentieren. Vorzugsweise repräsentieren die zweiten Sensordaten jedoch ausschließlich mindestens eine Größe der zuvor genannten Gruppe von Größen. Die Größen der zuvor genannten Gruppe haben vorzugsweise gemeinsam, dass sie durch die von den ersten Sensordaten repräsentierten Größen sowie von dem Systemverhalten des Leistungstransformators beeinflusst sind.

Für die Größen, die von den ersten und zweiten Sensordaten repräsentiert sind, gilt jeweils, dass die Vorrichtung oder ein System mit der Vorrichtung für jede repräsentierte und sensorisch erfasste Größe einen jeweils dazu geeigneten Sensor aufweisen kann. Zur Temperaturmessung kann die Vorrichtung oder das System beispielsweise einen oder mehrere Sensoren aufweisen. Für die elektrische Spannung kann die Vorrichtung oder das System einen entsprechenden Sensor zur Erfassung einer elektrischen Spannung aufweisen. Analoges gilt für die weiteren Größen, die tatsächlich von den ersten und zweiten Sensordaten repräsentiert sind. Zwei oder weitere Sensoren können miteinander integriert ausgestaltet sein. So kann ein entsprechend integrierter Sensor beispielsweise zur Erfassung von einem elektrischen Strom, einer elektrischen Spannung und einer elektrischen Leistung ausgebildet sein.

Eine weitere vorteilhafte Ausgestaltung der Vorrichtung zeichnet sich dadurch aus, dass die ersten und zweiten Sensordaten eines Messdatensatzes jeweils die zugehörigen Größen als eine Folge von periodisch und sensorisch erfassten Abtastwerten der Größen repräsentiert. Die Abtastwerte bilden vorzugsweise die Werte der Größen, die während eines Zeitraums aufgetreten sind, der zu dem Zeitfenster korrespondiert. Die ersten und zweiten Sensordaten eines Messdatensatzes repräsentieren also jeweils Größen aus dem gleichen Zeitraum, der zu dem jeweiligen Zeitfenster korrespondiert.

Eine weitere vorteilhafte Ausgestaltung der Vorrichtung zeichnet sich dadurch aus, dass die Vorrichtung konfiguriert ist, sodass in jedem Zeitfenster ein zugehöriger Messdatensatz aus ersten und zweiten Sensordaten erzeugt wird, die die zugehörigen Größen über einen vorbestimmten Zeitraum repräsentieren. Die Dauer eines jeden vorbestimmten Zeitraums ist vorzugsweise für jeden Messdatensatz und somit für jedes Zeitfenster gleich. Vorzugsweise ist jedes Zeitfenster zeitlich gleichlang. So kann jedes Zeitfenster beispielsweise eine Dauer von 24 Stunden aufweisen.

Eine weitere vorteilhafte Ausgestaltung der Vorrichtung zeichnet sich dadurch aus, dass der vorbestimmte Zeitraum größer als die größte Zeitkonstante des Leistungstransformators ist. Vorzugsweise beträgt der vorbestimmte Zeitraum mindestens das Zweifache, insbesondere mindestens das Zehnfache der größten Zeitkonstante des Leistungstransformators. Dies bietet den Vorteil, dass die Anpassung der Modellparameter, insbesondere durch das gruppenweise Wiederholen der Schritte a) bis c), nur langsam im Vergleich zu der durch die Zeitkonstante bestimmte Dynamik des Leistungstransformators erfolgt. Dies wiederum erlaubt eine gegenüber Störgrößen robuste Optimierung der Modellparameter.

Eine weitere vorteilhafte Ausgestaltung der Vorrichtung zeichnet sich dadurch aus, dass der vorbestimmte Zeitraum mindestens zwei Stunden, mindestens vier Stunden, mindestens acht Stunden, mindestens sechszehn Stunden, mindestens vierundzwanzig Stunden, oder mindestens zwei Tage beträgt. In der Praxis wurde festgestellt, dass der vorbestimmte Zeitraum für jedes Zeitfenster nicht zu kurz gewählt werden sollte, um nur eine langsame Anpassung der Modellparameter zu gewährleisten. Ein zu großer Zeitraum könnte jedoch zu einer zu trägen Anpassung der Modellparameter führen. Der vorbestimmte Zeitraum ist deshalb vorzugsweise mindestens zwei, vier, acht oder mindestens vierundzwanzig Stunden. Es ist jedoch auch bevorzugt vorgesehen, dass der vorbestimmte Zeitraum kleiner als zehn Tage, vorzugsweise kleiner als fünf Tage und vorzugsweise kleiner als vier Tage ist.

Eine weitere vorteilhafte Ausgestaltung der Vorrichtung zeichnet sich dadurch aus, dass das Simulationsmodell basierend auf einem IEEE Annex G-Modell für den Leistungstransformators ausgebildet ist. Dieses Modell kann der Veröffentlichung mit dem Titel "IEEE Guide for Loading Mineral-Oil-Immersed Transformers and Step-Voltage-Regulators", der über die Webseite www.ieee.org verfügbar ist, entnommen werden.

Eine weitere vorteilhafte Ausgestaltung der Vorrichtung zeichnet sich dadurch aus, dass das Simulationsmodell basierend auf einem IEC-Modell für den Leistungstransformator ausgebildet ist. Das IEC-Modell wird von der International Electrotechnical Commission (www.iec.ch) herausgegeben und basiert auf dem Standard IEC 60076-7. Als vorteilhaft hat sich die Version "Edition 2.0 2018-01" herausgestellt, die den Titel "Loading guide for mineral-oil-immersed power transformers" bzw. "Power transformers - Part 7: Loading guide for mineral-oil-immersed power transformers" trägt.

Eine weitere vorteilhafte Ausgestaltung der Vorrichtung zeichnet sich dadurch aus, dass die Vorrichtung ausgebildet ist, ein Ausgangssignal, das den Modellwert repräsentiert, mittels der Signalschnittstelle oder einer anderen Schnittstelle zu übertragen. Vorzugsweise kann die Prozessoreinheit konfiguriert sein, dass Ausgangssignal zu erzeugen. Über das Ausgangssignal kann der Modellwert einer übergeordneten Einheit und/oder einer übergeordneten Vorrichtung zur Verfügung gestellt werden. Das Ausgangssignal kann mittels der Signalschnittstelle oder der anderen Signalschnittstelle an die jeweilige Einheit bzw. Vorrichtung gesendet werden. Die übergeordnete Vorrichtung kann beispielsweise eine Leitstelle für mehrere Leistungstransformatoren und Vorrichtungen gemäß dem ersten Aspekt der Erfindung sein.

Eine weitere vorteilhafte Ausgestaltung der Vorrichtung zeichnet sich dadurch aus, dass die Prozessoreinheit konfiguriert ist, die jeweils zuletzt für ein Zeitfenster ermittelten Optimierungsparametern als Abschlussparameter für das jeweilige Zeitfenster zu bestimmen, Trendparameter durch Approximation mit der Mehrzahl der Abschlussparameter zu ermitteln, die Trendparameter mit zugehörigen, vorbestimmten Grenzwerten zu vergleichen, und bei einem Überschreiten von einem der Grenzwerte einen ersten Warnzustand für den Leistungstransformator zu bestimmen. Für jedes Zeitfenster wird die Gruppe der Schritte a) bis c) mehrfach wiederholt. Bei dem letzten Ausführen des Schritts c) der Wiederholungen werden Optimierungsparameter ermittelt, die als Abschlussparameter für das jeweilige Zeitfenster bestimmt werden. Hierzu ist die Prozessoreinheit entsprechend konfiguriert. Da die Prozessoreinheit außerdem dazu konfiguriert ist, mehrere nacheinander folgende Zeitfenster mit jeweils zugehörigen Messdaten zu erzeugen, wird aufgrund der Mehrzahl der Zeitfenster auch eine entsprechende Mehrzahl von Abschlussparametern bestimmt. Die Prozessoreinheit ist konfiguriert, basierend auf dieser Mehrzahl der Abschlussparameter einer Approximation auszuführen und dadurch Trendparameter zu ermitteln. Diese Trendparameter können beispielsweise die Abschlussparameter für zukünftige Zeitfenster repräsentieren. Sie können jedoch auch Abweichung gegenüber dem letzten Abschlussparameter oder einem Mittelwert der Abschlussparameter zu dem in der Zukunft approximierten Abschlussparameter repräsentieren. Weiterhin ist die Prozessoreinheit dazu konfiguriert, die durch Approximation ermittelten Trendparameter mit zugehörigen, vorbestimmten Grenzwerten zu vergleichen. Die Trendparameter weisen vorzugsweise die gleiche Dimension wie die Optimierungsparameter auf. Die Trendparameter können somit einen Vektor bilden, wobei die Grenzwerte zu jedem Eintrag des Vektors einen entsprechenden Grenzwert umfassen. Jeder der Trendparameter kann also mit einem zugehörigen, vorbestimmten Grenzwert verglichen werden. Hierzu ist die Prozessoreinheit bevorzugt entsprechend konfiguriert. Die Trendparameter und der Vergleich mit den Grenzwerten bietet die Möglichkeit, einen Warnzustand zu bestimmen, wenn einer der Trendparameter oder mehrere der Trendparameter den bzw. die zugehörigen Grenzwerte überschreiten. Die Prozessoreinheit ist deshalb dazu konfiguriert, beim Überschreiten von einem der Grenzwerte oder mehreren der Grenzwerte einen ersten Warnzustand für den Leistungstransformator zu bestimmen. Dieser erste Warnzustand kann darauf hindeuten, dass der Leistungstransformator in Zukunft in einem problematischen oder kritischen Zustand sein wird. Anhand der Trendparameter ist deshalb ablesbar, ob sich das Simulationsmodell und damit auch das tatsächliche Systemverhalten des Leistungstransformators in Zukunft in einen problematischen oder kritischen Zustand verändern könnte

Gemäß einem zweiten Aspekt der Erfindung wird die eingangs genannte Aufgabe gelöst durch ein System mit den Merkmalen des Anspruchs 18. Das System weist eine Mehrzahl von Vorrichtungen auf. Jede der Vorrichtungen ist gemäß dem ersten Aspekt der Erfindung und/oder einer der zugehörigen, vorteilhaften Ausgestaltungen ausgebildet. Für jede der Vorrichtungen des Systems wird deshalb auf die vorteilhaften Erläuterungen, bevorzugten Merkmale, technischen Effekte und/oder Vorteile in analoger Weise Bezug genommen, wie sie zu dem ersten Aspekt der Erfindung oder einer der zugehörigen, vorteilhaften Ausgestaltungen bereits erläutert worden sind.

Das System gemäß dem zweiten Aspekt der Erfindung ist ausgebildet, die von den Vorrichtungen jeweils bestimmten Modellparameter untereinander zu vergleichen und dadurch jeweils Modellparameterdifferenzen zu bestimmen. Das System ist außerdem ausgebildet, die Modelldifferenzparameter jeweils mit zugehörigen, vorbestimmten Grenzwerten zu vergleichen, und bei einem Überschreiten von einem der Grenzwerte der Modellparameter, die die Überschreitung verursachen, und den zugehörigen Leistungstransformator zu identifizieren, und für den identifizierten Leistungstransformator einen zweiten Warnzustand zu bestimmen.

Das System weist vorzugsweise außerdem eine Mehrzahl von Leistungstransformatoren auf. Jedem Leistungstransformator ist jeweils eine der zuvor genannten Vorrichtungen des Systems zugeordnet, sodass die jeweils einem Leistungstransformator zugeordnete Vorrichtung ausgebildet ist, um über ein Messsignal erste und zweite Sensordaten zu empfangen, die jeweils mindestens eine in oder an dem jeweils zugeordneten Leistungstransformator sensorisch erfasste Größe repräsentieren. Außerdem ist es bevorzugt vorgesehen, dass die Leistungstransformatoren vom gleichen Typ und/oder baugleich ausgebildet sind. Dadurch ist es möglich, dass das Systemverhalten der Leistungstransformatoren untereinander vergleichbar ist. Die Simulationsmodelle der Vorrichtungen sind durch die jeweils zugehörigen Modellparameter derart eingestellt, dass sie das Systemverhalten der jeweils zugeordneten Leistungstransformatoren simulieren können. Der Vergleich der Modellparameter der mehreren Vorrichtungen kann deshalb zu einem analogen Ergebnis führen wie ein Vergleich der Systemverhalten der mehreren Leistungstransformatoren des Systems. Anhand der Modellparameterdifferenzen ist deshalb ablesbar, ob sich das Systemverhalten der Leistungstransformatoren stark unterscheidet. Wenn einer der Leistungstransformatoren ein stark abweichendes, insbesondere gegenüber einem Mittelwert der übrigen Leistungstransformatoren stark abweichendes Systemverhalten aufweist, so werden die Modellparameter des Simulationsmodells für diesen abweichenden Leistungstransformator ebenfalls mit größeren Modellparameterdifferenzen von den übrigen Modellparametern der anderen Vorrichtungen abweichen. Überschreiten Modellparameterdifferenzen zugehörige, vorbestimmte Grenzwerte, ist dies ein Indiz dafür, dass die Modellparameter, die die Überschreitung verursachen, einem Simulationsmodell einer Vorrichtung zugeordnet sind, die ein Messsignal von einem Leistungstransformator empfängt, der in einem problematischen oder kritischen Zustand ist. Über die Modellparameter lässt sich deshalb ein Leistungstransformator identifizieren, für den ein zweiter Warnzustand zu bestimmen ist. Die Prozessoreinheit ist deshalb vorzugsweise dazu konfiguriert, die Modellparameter für ein Simulationsmodell zu bestimmen, die die Überschreitung von zugehörigen Grenzwerten verursachen und basierend auf den Modellparametern und dem zugehörigen Simulationsmodell die zugehörige Vorrichtung sowie den zugehörigen Leistungstransformator zu identifizieren, von dem die identifizierte Vorrichtung das Messsignal empfängt, das die ersten und zweiten Sensordaten repräsentiert, die wiederum jeweils sensorisch erfasste Größen des identifizierten Leistungstransformators repräsentieren. Das System ist vorzugsweise außerdem dazu ausgebildet, für diesen identifizierten Leistungstransformator einen zweiten Warnzustand zu bestimmen. Ist der zweite Warnzustand bestimmt, so können Folgemaßnahmen ergriffen werden, um den identifizierten Leistungstransformator zu überprüfen und gegebenenfalls Reparaturmaßnahmen einzuleiten.

Weitere Merkmale, Vorteile und Anwendungsmöglichkeiten der vorliegenden Erfindung ergeben sich aus der nachfolgenden Beschreibung der Ausführungsbeispiele und den Figuren. Dabei bilden alle beschriebenen und/oder bildlich dargestellten Merkmale für sich und in beliebiger Kombination den Gegenstand der Erfindung auch unabhängig von ihrer Zusammensetzung in den einzelnen Ansprüchen oder deren Rückbezügen. In den Figuren stehen weiterhin gleiche Bezugszeichen für gleiche oder ähnliche Objekte.

Figur 1    zeigt eine vorteilhafte Ausgestaltung eines Systems mit einem Leistungstransformator und eine vorteilhafte Ausgestaltung einer Vorrichtung in einer schematischen Darstellung.

Figur 2    zeigt eine beispielhafte Gruppe von Schritten a) bis c) in einer schematischen Darstellung.

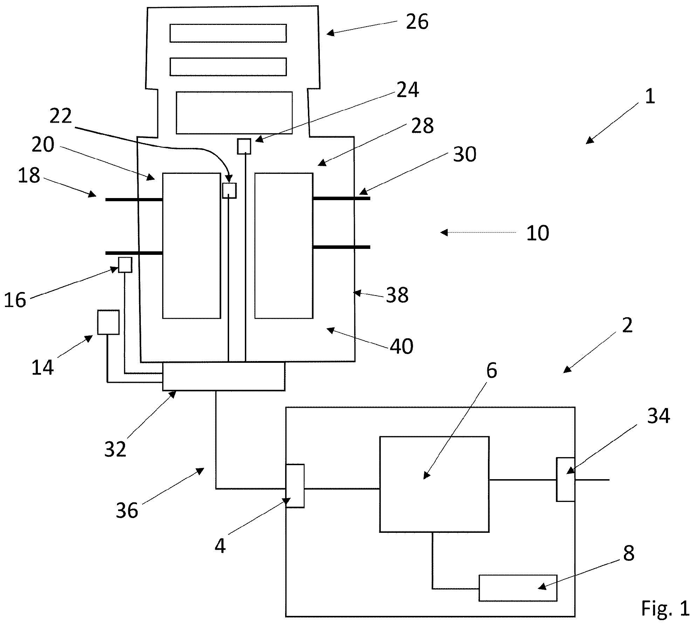

In der Figur 1 ist eine vorteilhafte Ausgestaltung eines Systems 1 dargestellt. Das System 1 umfasst einen Leistungstransformator 10 sowie eine Vorrichtung 2.

Wenn im Folgenden vorteilhafte Merkmale, technische Effekte und/oder Vorteile zu der Vorrichtung 2 erläutert werden, so können diese Erläuterungen auch für eine Ausgestaltung der Vorrichtung 2 gelten, die nicht Teil des Systems 1 ist, und/oder für eine Vorrichtung 2 gelten, die einen Teil des Systems 1 bildet. Der Leistungstransformator 10 kann einen weiteren Teil des Systems 1 bilden.

Der Leistungstransformator 10 des Systems 1 weist ein Gehäuse 38 auf, in dem ein Spulenpaket 20 der Primärseite und ein weiteres Spulenpaket 28 der Sekundärseite des Leistungstransformators 10 angeordnet sind. Das Spulenpaket 20 der Primärseite ist über einen Kern, insbesondere einen Ringkern, elektromagnetisch mit dem Spulenpaket 28 der Sekundärseite gekoppelt. Außerdem weist der Leistungstransformator 10 an der Primärseite Anschlüsse 18 auf, die eine elektrische Verbindung zu dem Spulenpaket 20 der Primärseite bilden. In analoger Weise sind Anschlüsse 30 für die Sekundärseite vorgesehen, die elektrisch mit dem Spulenpaket 28 der Sekundärseite verbunden sind. Jedes der beiden Spulenpakete 20, 28 weist eine Vielzahl von Windungen auf. Beim Betrieb des Leistungstransformators 10 fällt zwischen den Anschlüssen 18 an der Primärseite eine Spannung ab, die wiederum zu einem Strom durch die Anschlüsse 18 und die Windungen des Spulenpakets 20 der Primärseite führt. Dadurch wird an der Primärseite eine elektrische Leistung aufgenommen. An der Sekundärseite fällt zwischen den Anschlüssen 30 ebenfalls eine Spannung ab und es fließt ein Strom durch die Anschlüsse 30 sowie durch die Windungen des Spulenpakets 28 an der Sekundärseite. An der Sekundärseite wird deshalb eine elektrische Leistung zur Verfügung gestellt. Der Leistungstransformator 10 dient deshalb zur Übertragung und Wandlung von elektrischer Leistung von der Primärseite zu der Sekundärseite. Dabei entsteht Wärme, die von einer Kühlflüssigkeit 40, die vorzugsweise von einem Öl gebildet ist, aufgenommen werden kann. Die Kühlflüssigkeit 40 ist ebenfalls in dem Innenraum des Gehäuses 38 aufgenommen, und kann die an den Windungen der Spulenpakete 20, 28 entstehende Wärme aufnehmen und zu einem Kühler 26 leiten. Bei dem Kühler 26 handelt es sich vorzugsweise um einen Ölkühler zur Kühlung des Öls, das vorzugsweise die Kühlflüssigkeit 40 bildet.

Die Kühlflüssigkeit 40 wird durch einen Wärmestrom zwischen den Windungen der Spulenpakete 20, 28 an der Primär- bzw. Sekundärseite erwärmt. Insbesondere an den Windungen der Primärseite kann deshalb ein besonders heißer Punkt in der Kühlflüssigkeit 40 entstehen, wo die Kühlflüssigkeit besonders heiß ist. Es wird deshalb vorzugsweise ein Windungstemperatursensor 22 an oder in eine Windung befestigt, um die Temperatur an bzw. in einer Windung zu ermitteln. Diese Temperatur wird auch als Hot-Spot-Temperatur bezeichnet. Der Windungstemperatursensor 22 ist vorzugsweise ein Temperatursensor, der zur Erfassung einer Temperatur an oder in einer Windung ausgebildet ist. Wie aus der Figur 1 schematisch und beispielhaft zu erkennen ist, kann der Windungstemperatursensor 22 beispielsweise an einer Windung des Spulenpakets 20 an der Primärseite befestigt sein. Der Windungstemperatursensor 22 kann über eine Signalverbindung mit einer Erfassungseinheit 32 des Leistungstransformators 10 verbunden sein. Mit dieser Erfassungseinheit 32 sind vorzugsweise noch weitere Sensoren des Leistungstransformators 10 gekoppelt. Wie aus der Figur 1 beispielhaft zu erkennen ist, weist der Leistungstransformator 10 außerdem und bevorzugt einen Öltemperatursensor 24 auf. Der Öltemperatursensor 24 ist innerhalb des Gehäuses 38 des Leistungstransformators 10 angeordnet, und zwar vorzugsweise in der Art, dass der Öltemperatursensor 24 die Temperatur der Kühlflüssigkeit 40 in einem oberen Bereich im Innenraum des Gehäuses 38 erfasst. Somit kann der Öltemperatursensor 24 beispielsweise derart angeordnet sein, um die sogenannte Top-Oil-Temperatur zu erfassen. Der Öltemperatursensor 24 ist über eine zugehörige Signalverbindung mit der Erfassungseinheit 32 gekoppelt. Weiterhin ist es bevorzugt vorgesehen, dass der Leistungstransformator 10 einen Umgebungstemperatursensor 14 aufweist. Der Umgebungstemperatursensor 14 muss dazu nicht zwingend an dem Gehäuse 38 des Leistungstransformators 10 befestigt sein, was jedoch möglich ist. Vielmehr ist es bevorzugt vorgesehen, dass der Umgebungstemperatursensor 14 einen Teil des Leistungstransformators 10 bildet, ohne einen thermischen Kontakt zu dem Gehäuse 38 aufzuweisen. Der Umgebungstemperatursensor 14 kann somit dem Leistungstransformator 10 zumindest zugeordnet sein und in der Nähe des Gehäuses 38 angeordnet sein. Der Umgebungstemperatursensor 14 ist über eine zugehörige Signalverbindung mit der Erfassungseinheit 32 gekoppelt. Der Leistungstransformator 10 weist vorzugsweise außerdem einen Stromsensor 16 auf, der zur Erfassung eines Stroms durch einen Anschluss 18 des Leistungstransformators 10 fließt. In der Figur 1 ist der Stromsensor 16 beispielsweise an einem der Anschlüsse 18 an der Primärseite angeordnet, um den Strom durch die Anschlüsse 18 zu erfassen. Der Stromsensor 16 ist über eine zugehörige Signalverbindung mit der Erfassungseinheit 32 gekoppelt. Der Umgebungstemperatursensor 14 und der Stromsensor 16 erfassen jeweils physikalische Größen bzw. Eigenschaften, die von außen auf den Leistungstransformator 10 wirken. Der Windungstemperatursensor 22 und der Öltemperatursensor 24 erfassen jeweils physikalische Größen bzw. Eigenschaften, die innerhalb des Leistungstransformators 10, insbesondere innerhalb des Gehäuses 38 des Leistungstransformators 10 bestehen. Es ist deshalb vorgesehen, dass beispielsweise der Umgebungstemperatursensor 14 und der Stromsensor 16 erste Sensordaten erzeugen und dass der Windungstemperatursensor 22 und der Öltemperatursensor 24 zweite Sensordaten erzeugen. Die Sensordaten der Sensoren 14, 16, 22, 24 können über die jeweiligen Signalverbindungen an die Erfassungseinheit übertragen werden. Die Erfassungseinheit 32 kann dazu ausgebildet sein, um ein Messsignal zu erzeugen, das die ersten Sensordaten und die zweiten Sensordaten repräsentiert. Die Erfassungseinheit 32 kann das Messsignal über die Signalverbindung 36 an eine Signalschnittstelle 4 der Vorrichtung 2 senden. Auf diese Weise werden der Vorrichtung 2 die ersten Sensordaten und die zweiten Sensordaten zur Verfügung gestellt, die jeweils mindestens eine an bzw. in dem Leistungstransformator 10 sensorisch erfasste Größe repräsentieren.

Leistungstransformatoren 10 mit einer Vielzahl von Sensoren sind zwar wünschenswert, jedoch in der Praxis werden oftmals nicht alle theoretisch verfügbaren und möglichen Sensoren verbaut. Insbesondere kann es vorkommen, dass ein Leistungstransformator 10 keinen Windungstemperatursensor 22 aufweist. Dies ist in der Figur 1 beispielsweise für die Windungen des Spulenpakets 28 an der Sekundärseite 30 der Fall. Für die weitere Erläuterung wird rein beispielhaft davon ausgegangen, dass der in Figur 1 dargestellte Leistungstransformator 10 keinen Windungstemperatursensor 22 aufweist, obwohl die Temperatur der Windungen jedoch von besonderem Interesse ist.

Ausgehend von der Annahme, dass der zuvor erläuterte Leistungstransformator 10 nicht den Windungstemperatursensor 22 aufweist, ist festzustellen, dass die zweiten Sensordaten nicht die Temperatur der Windungen repräsentieren können. Die zweiten Sensordaten können beispielsweise ausschließlich von dem Öltemperatursensor 24 gespeist sein. Mit anderen Worten können die zweiten Sensordaten beispielsweise die Öltemperatur der als Öl ausgebildeten Kühlflüssigkeit 40 in einem oberen, inneren Bereich des Gehäuses 38 repräsentieren. Um dennoch Aufschluss über die Temperatur an den Windungen beispielsweise des Spulenpakets 20 der Primärseite zu erhalten, ist die Vorrichtung 2 vereinfacht betrachtet dazu ausgebildet, um einen sogenannten Modellwert zu ermitteln, der beispielsweise die Temperatur einer Windung des Spulenpakets 20 an der Primärseite repräsentiert, obwohl die Temperatur nicht sensorisch erfasst wird.

Die Vorrichtung 2 weist eine Signalschnittstelle 4, eine Prozessoreinheit 6 und eine Speichereinheit 8 auf. Bei der Speichereinheit 8 handelt es sich vorzugsweise um eine Speichereinheit zum Speichern von Daten. Die Prozessoreinheit 6 ist ausgebildet, um mathematische Operationen und/oder Signalverarbeitungen auszuführen. Die Prozessoreinheit 6 kann dazu einen Mikroprozessor umfassen. Die Signalschnittstelle 4 ist zum Empfang des Messsignals ausgebildet, das die ersten Sensordaten und die zweiten Sensordaten repräsentiert. Dieses Messsignal kann die Signalschnittstelle 4 von der Erfassungseinheit 32 und über die Signalverbindung 36 empfangen. Die Signalschnittstelle 4 ist vorzugsweise derart mit der Prozessoreinheit 6 gekoppelt, sodass die ersten Sensordaten und die zweiten Sensordaten für die Prozessoreinheit 6 zur Verfügung gestellt werden. Die Signalschnittstelle 4 und die Prozessoreinheit 6 können integral ausgebildet sein.

Die Prozessoreinheit 6 ist konfiguriert, in zeitlich aufeinanderfolgenden Zeitfenstern jeweils einen Messdatensatz aus den im jeweiligen Zeitfenster empfangenen ersten und zweiten Sensordaten zu erzeugen. Die Dauer eines Zeitfensters beträgt vorzugsweise 24 Stunden. Außerdem ist es bevorzugt vorgesehen, dass alle vier Stunden ein neues Zeitfenster mit dem zugehörigen Messdatensatz erzeugt wird. Die einem Zeitfenster zugeordneten Messdatensätze können deshalb teilweise gleiche erste und zweite Sensordaten umfassen. Außerdem können sich die Zeitfenster in dem zuvor genannten Beispiel jeweils um sechszehn Stunden überlappen, wenn zwei aufeinanderfolgende Zeitfenster betrachtet werden.

In der Speichereinheit 8 ist ein mathematisches Simulationsmodell des Leistungstransformators 10 gespeichert. Die Prozessoreinheit 6 ist zum Laden und Ausführen des Simulationsmodells konfiguriert. Das Simulationsmodell ist derart ausgestaltet, dass das Simulationsmodell ein Übertragungsverhalten des Leistungstransformators 10 repräsentiert. Da es sich bei dem Simulationsmodell um ein mathematisches Modell handelt, können Eingangsdaten von dem Simulationsmodell beim Ausführen verarbeitet werden, sodass durch die Verarbeitung Ausgangsdaten entstehen. Die Ausgangsdaten hängen also von den Eingangsdaten ab. Das Übertragungsverhalten des Simulationsmodells ist jedoch veränderbar, und zwar durch zugehörige Modellparameter. Die Ausgangsdaten hängen also sowohl von den Modellparametern des Simulationsmodells als auch von den Eingangsdaten ab, mit dem das Simulationsmodell ausgeführt wird. Die Prozessoreinheit 6 ist ausgebildet, das Simulationsmodell mit den Eingangsdaten und den zugehörigen Modellparametern für das Simulationsmodell auszuführen und dadurch Ausgangsdaten zu erzeugen. Modellparameter, zumindest als Startparameter zum Ausführen des Simulationsmodells, können in der Speichereinheit 8 gespeichert sein und/oder von der Prozessoreinheit 6 geladen werden. Das Simulationsmodell ist außerdem ausgebildet, bei der Ausführung nicht nur die Ausgangsdaten zu erzeugen, sondern auch einen Modellwert zu erzeugen, und zwar für eine Temperatur innerhalb des Leistungstransformators 10 in Abhängigkeit von den Eingangsdaten und Modellparametern, die beim Ausführen verwendet werden. Der Modellwert kann somit auch ein Ergebnis der Ausführung des Simulationsmodells sein. Die Prozessoreinheit 6 ist ausgebildet, das Simulationsmodell entsprechend auszuführen, um den Modellwert zu ermitteln. Das Simulationsmodell kann beispielsweise derart ausgestaltet sein, dass der Modellwert die Temperatur an einer Windung von einer der Spulenpakete 20, 28 repräsentiert. Vorzugsweise ist es vorgesehen, dass das Simulationsmodell derart ausgestaltet ist, dass der Modellwert die Temperatur an einer Windung des Spulenpakets 20 an der Primärseite 20 repräsentiert. In Abhängigkeit von der Ausgestaltung des Simulationsmodells und vorzugsweise auch basierend auf dem Bedarf, welche Temperatur in dem Leistungstransformator 10 mittels des Simulationsmodells ermittelt werden soll, kann der Modellwert auch eine andere Temperatur innerhalb des Leistungstransformators 10 abbilden. So kann der Modellwert beispielsweise die Top-Oil-Temperatur oder eine Temperatur der Kühlflüssigkeit 40 in dem Kühler 26 repräsentieren.

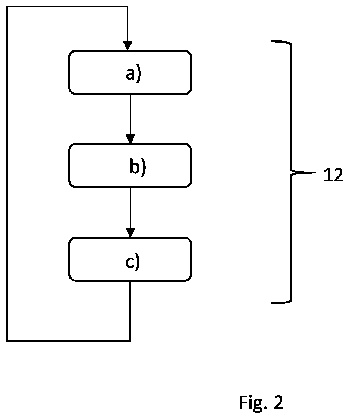

Da der mittels des Simulationsmodells ermittelte Modellwert jedoch nicht nur von den Eingangsdaten sondern auch von den Modellparametern für das Simulationsmodell abhängt, ist es wünschenswert, dass die Modellparameter besonders vorteilhaft gewählt werden, sodass das Simulationsmodell das Übertragungsverhalten des Leistungstransformators 10 besonders präzise abbildet. Es ist deshalb vorgesehen, dass eine beispielsweise in Figur 2 dargestellte Gruppe 12 von Schritten a), b) und c) gruppenweise wiederholt ausgeführt werden, um Modellparameter für das Simulationsmodell zu ermitteln, die eine besonders präzise Simulation des Leistungstransformators 10 mit dem Simulationsmodell erlauben. Bei der gruppenweisen Wiederholung wird jede Gruppe 12 von Schritten a) bis c) vollständig ausgeführt, bevor die gleiche Gruppe 12 von Schritten a) bis c) erneut und somit wiederholt ausgeführt wird. Bei der gruppenweisen Wiederholung werden die Schritte a) bis c) der jeweiligen Gruppe 12 nicht parallel ausgeführt, sondern nacheinander. Es findet auch keine Ausführung von Schritten von parallelen Gruppen 12 statt. Die Gruppen 12 werden also nacheinander ausgeführt und in jeder Gruppe 12 werden die Schritte a) bis c) nacheinander ausgeführt. Dadurch entsteht die gruppenweise Wiederholung.

Die Prozessoreinheit 6 ist konfiguriert, in Schritt a) Ausgangsdaten durch Ausführen des Simulationsmodells mit Eingangsdaten zu ermitteln, die von ersten Sensordaten des dem jeweiligen Zeitfenster zugeordneten Messdatensatzes bestimmt sind, und Modellparametern, die beim erstmaligen Ausführen des Simulationsmodells für das jeweilige Zeitfenster von vorbestimmten Referenzdaten und ansonsten von den jeweils zuletzt ermittelten Optimierungsparametern bestimmt sind. Die Referenzparameter können Startparameter für die Modellparameter sein. Damit ist es möglich, das Simulationsmodell auszuführen. Die Referenzdaten können in der Speichereinheit 8 gespeichert sein und/oder von der Prozessoreinheit aus der Speichereinheit 8 geladen werden.

Die ersten Sensordaten werden bei dem in Figur 1 gezeigten Beispiel durch die Sensordaten des Umgebungstemperatursensors 14 und des Stromsensors 16 gebildet. Die ersten Sensordaten können in diesem Fall also die Umgebungstemperatur zum Leistungstransformator 10 und den Strom an der Primärseite des Leistungstransformators 10 repräsentieren. Durch das Ausführen des Simulationsmodells mit den ersten Sensordaten als Eingangsdaten und den Referenzparametern als Modellparametern werden Ausgangsdaten erzeugt. Das Simulationsmodell kann dabei derart ausgestaltet sein, dass die Ausgangsdaten Größen des simulierten Leistungstransformators 10 repräsentieren, die zu den von den zweiten Sensordaten sensorisch erfassten Größen korrespondieren. In dem in Figur 1 beispielhaft dargestellten Beispiel können durch die Ausführung des Simulationsmodells also Ausgangsdaten erzeugt werden, die eine simulierte Top-Oil-Temperatur für die Kühlflüssigkeit 40 im Innenraum des Gehäuses 38 des Leistungstransformators 10 repräsentieren.

Gemäß Schritt b) ist es vorgesehen, dass mittels der Prozessoreinheit 6 ein Zielwert ermittelt wird, der zumindest einen mit einem ersten Gewichtungsfaktor gewichteten, quadratischen Fehler zwischen den zweiten Sensordaten des dem jeweiligen Zeitfenster zugeordneten Messdatensatzes und den zuvor in Schritt a) ermittelten Ausgangsdaten umfasst. In Bezug auf das in Figur 1 dargestellte Beispiel repräsentieren die zweiten Sensordaten die mit dem Öltemperatursensor 24 erfasste Top-Oil-Temperatur. Die in Schritt a) ermittelten Ausgangsdaten repräsentieren eine simulierte Top-Oil-Temperatur für die Kühlflüssigkeit 40 im Innenraum des Gehäuses 38 des Leistungstransformators 10. Der Fehler zwischen den zweiten Sensordaten und den Ausgangsdaten kann somit ein positiver als auch ein negativer Fehler sein, in Abhängigkeit von dem jeweiligen Abtastwert. Durch den quadratischen Fehler wird verhindert, dass es auf das mathematische Vorzeichen des Fehlers ankommt. Der erste Gewichtungsfaktor kann derart gewählt werden, um den Zielwert entsprechend zu berechnen.

Eine beispielhafte, mathematische Funktion zur Ermittlung des Zielwerts ist im Folgenden wiedergegeben:

$$E(p) = \int c_a \big(m(t,p) - s(t,p)\big)^2 \, dt + \sum c_d (p_i - p_{i,pre})^2 + \sum c_r (p_i - p_{i,0})^2$$

Der Zielwert $E(p)$ hängt dabei von drei Komponenten ab. Die erste Komponente mit dem ersten Integralzeichen repräsentiert den mit dem ersten Gewichtungsfaktor $c_a$ gewichteten, quadratischen Fehler zwischen den zweiten Sensordaten $m$ und den in Schritt a) ermittelten Ausgangsdaten $s$. Jedes der beiden weiteren Komponenten des Zielwerts beginnt mit einem Summenzeichen. Bei der zweiten Komponente wird ein zweiter Gewichtungsfaktor $c_d$ und bei der dritten Komponente ein dritter Gewichtungsfaktor $c_r$ berücksichtigt.

Bevorzug ist es vorgesehen, dass die Vorrichtung 2 konfiguriert ist, den Zielwert E in Schritt b) ab der Ausführung für das zweite Zielfenster jeweils derart zu ermitteln, sodass der Zielwert E außerdem eine mit dem zweiten Gewichtungsfaktor $c_d$ gewichtete, quadratische Differenz $(p_i - p_{i,pre})^2$ zwischen den zuletzt bestimmten Modellparametern $p_i$ und den als letztes für das vorherige Zeitfenster Optimierungsparametern $p_{i,pre}$ umfasst. Die zweite Komponente des Zielwerts E kann durch eine Wahl des zweiten Gewichtungsfaktors ca dazu beitragen, dass ein schneller Wechsel zwischen den Modellparametern verhindert wird. Dadurch ist das Simulationsmodell robust gegenüber äußeren Störgrößen.

Weiterhin ist es bevorzugt vorgesehen, dass die Vorrichtung 2 konfiguriert ist, den Zielwert E in Schritt b) derart zu ermitteln, sodass der Zielwert E außerdem eine mit dem dritten Gewichtungsfaktor $c_r$ gewichtete, quadratische Differenz $(p_i - p_{i,o})_2$ zwischen den zuletzt bestimmten Modellparametern $p_i$ und den Referenzparametern $p_{i,o}$ umfasst. Die dritte Komponente des Zielwerts E kann durch eine geeignete Wahl des dritten Gewichtungsfaktors $c_r$ im Verhältnis zu dem ersten und zweiten Gewichtungsfaktor $c_a$ und ca kleiner gewählt werden, um den anderen Komponenten ein stärkeres Gewicht zu verleihen. Durch eine geeignete Wahl des dritten Gewichtungsfaktors $c_r$ kann jedoch verhindert werden, dass es zu einer starken Abweichung zwischen den anfänglichen Referenzparametern $p_{i,o}$ und den jeweils aktuellen Modellparametern $p_i$ kommt. Dabei wird davon ausgegangen, dass die anfänglichen Referenzparametern $p_{i,o}$ zumindest näherungsweise eine ausreichend gute Simulation des Übertragungsverhaltens des Leistungstransformators 10 mit dem Simulationsmodell erlaubt.

Außerdem ist die Prozessoreinheit 6 konfiguriert, in Schritt c) Optimierungsparameter als neue Modellparameter für das Simulationsmodell basierend auf dem mindestens einen im jeweiligen Zeitfenster ermittelten Zielwert aus Schritt b) zu ermitteln. So kann die Prozessoreinheit 6 beispielsweise dazu konfiguriert sein, ein Optimierungsverfahren auszuführen, um die Optimierungsparameter zu ermitteln. Dabei wird für das Optimierungsverfahren sowohl auf die in vorangegangenen Schritten b) ermittelten Zielwert als auch die in den vorherigen Schritten c) ermittelten Optimierungsparameter zurückgegriffen, um für das jeweilige aktuelle Ermitteln der Optimierungsparameter basierend auf dem Optimierungsverfahren neue Optimierungsparameter als Modellparameter für das Simulationsmodell zu ermitteln, die einen geringeren Zielwert in dem nächsten Schritt b) verursachen. Das Optimierungsverfahren kann somit derart ausgestaltet sein, um den Zielwert in Schritt c) möglichst klein zu halten und/oder zu minimieren. Dies ist deshalb sinnvoll, da der Zielwert quadratische Fehler oder quadratische Differenzen gewichtet umfasst, die möglichst klein gehalten werden sollten. Optimierungsverfahren sind grundsätzlich aus dem Stand der Technik bekannt und können bei der Ausführung der Gruppe 12 der Schritte a) bis c) Anwendung finden. Bevorzugt ist es vorgesehen, dass die Prozessoreinheit 6 konfiguriert ist, die Gruppe 12 der Schritte a) bis c) zwischen 10 und 1000 Mal zu wiederholen. In der Praxis wurde festgestellt, dass dadurch beim letztmaligen Ausführen des Schritts c) Optimierungsparameter als neue Modellparameter ermittelt werden können, die eine besonders vorteilhafte Simulation des Übertragungsverhaltens des Leistungstransformators 10 erlauben. Außerdem kann mit derartigen Modellparametern mittels des Simulationsmodells ein Modellwert für die Temperatur innerhalb des Leistungstransformators 10 ermittelt werden, der vorzugsweise nicht sensorisch erfasst ist. Die Prozessoreinheit 6 ist deshalb dazu konfiguriert, für jedes Zeitfenster den Modellwert durch Ausführen des Simulationsmodells mit Eingangsdaten, die von ersten Sensordaten des dem jeweiligen Zeitfenster zugeordneten Messdatensatzes bestimmt sind, und Modellparametern, die für das jeweilige Zeitfenster von dem jeweils zuletzt ermittelten Optimierungsparametern bestimmt sind, zu ermitteln. Dadurch lässt sich für jedes Zeitfenster ein besonders präziser Modellwert ermitteln, der somit auch die Temperatur innerhalb des Leistungstransformators 10 besonders präzise abbildet bzw. repräsentiert. Diese Temperatur kann beispielsweise die Temperatur an einer der Windungen von einem der Spulenpakete 20, 28 sein. Vorzugsweise weist die Vorrichtung 2 eine weitere Schnittstelle 34 auf, die mit der Prozessoreinheit 6 gekoppelt ist. Außerdem kann die Vorrichtung 2 derart ausgebildet sein, um mittels der weiteren Schnittstelle 34 ein Ausgangssignal zu übertragen, das den Modellwert, insbesondere den zuletzt ermittelten Modellwert, repräsentiert.

Ergänzend sei darauf hingewiesen, dass "aufweisend" keine anderen Elemente oder Schritte ausschließt und "ein" oder "eine" keine Vielzahl ausschließt. Ferner sei darauf hingewiesen, dass Merkmale, die mit Verweis auf eines der obigen Ausführungsbeispiele beschrieben worden sind, auch in Kombination mit anderen Merkmalen anderer oben beschriebener Ausführungsbeispiele verwendet werden können. Bezugzeichen in den Ansprüchen sind nicht als Einschränkung anzusehen.

BEZUGSZEICHENLISTE

| 1 | System |
|---|---|
| 2 | Vorrichtung |
| 4 | Signalschnittstelle |
| 6 | Prozessoreinheit |
| 8 | Speichereinheit |
| 10 | Leistungstransformator |
| 12 | Gruppe |
| 14 | Umgebungstemperatursensor |
| 16 | Stromsensor |
| 18 | Anschlüsse Primärseite |
| 20 | Spulenpaket Primärseite |
| 22 | Windungstemperatursensor |
| 24 | Öltemperatursensor |
| 26 | Kühler |
| 28 | Spulenpaket Sekundärseite |
| 30 | Anschlüsse Sekundärseite |
| 32 | Erfassungseinheit |
| 34 | weitere Signalschnittstelle |
| 36 | Signalverbindung |
| 38 | Gehäuse |
| 40 | Kühlflüssigkeit |

**Patentansprüche**

1. **Vorrichtung (2),** aufweisend:

eine Signalschnittstelle (4),
eine Prozessoreinheit (6), und
eine Speichereinheit (8),
wobei die Signalschnittstelle (4) zum Empfang eines Messsignals ausgebildet ist, das erste Sensordaten und zweite Sensordaten repräsentiert,
wobei die ersten und zweiten Sensordaten jeweils mindestens eine in oder an einem Leistungstransformator (10) sensorisch erfasste Größe repräsentieren,
wobei die Prozessoreinheit (6) konfiguriert ist, in aufeinanderfolgenden Zeitfenstern jeweils einen Messdatensatz aus den im jeweiligen Zeitfenster empfangenen ersten und zweiten Sensordaten zu erzeugen,
wobei in der Speichereinheit (8) ein Simulationsmodell des Leistungstransformators (10) gespeichert ist, das ein Übertragungsverhalten von Eingangsdaten zu Ausgangsdaten in Abhängigkeit von Modellparametern des Simulationsmodells abbildet,
wobei die Prozessoreinheit (6) konfiguriert ist, für jedes Zeitfenster die folgende Gruppe (12) von Schritten a) bis c) gruppenweise wiederholt auszuführen:

a) Ermittlung von Ausgangsdaten durch Ausführen des Simulationsmodells mit Eingangsdaten, die von ersten Sensordaten des dem jeweiligen Zeitfenster zugeordneten Messdatensatzes bestimmt sind, und Modellparametern, die beim erstmaligen Ausführen des Simulationsmodells für das jeweilige Zeitfenster von vorbestimmten Referenzparametern und ansonsten von den jeweils zuletzt ermittelten Optimierungsparametern bestimmt sind,

b) Ermittlung eines Zielwerts, der zumindest einen mit einem ersten Gewichtungsfaktor gewichteten, quadratischen Fehler zwischen den zweiten Sensordaten des dem jeweiligen Zeitfenster zugeordneten Messdatensatzes und den zuvor ermittelten Ausgangsdaten umfasst, und

c) Ermittlung von Optimierungsparametern als neue Modellparameter für das Simulationsmodell basierend auf dem mindestens einen im jeweiligen Zeitfenster ermittelten Zielwert,

wobei das Simulationsmodell außerdem einen Modellwert für eine Temperatur innerhalb des Leistungstransformators (10) in Abhängigkeit von Eingangsdaten und Modellparametern abbildet, und
wobei die Prozessoreinheit (6) konfiguriert ist, für jedes Zeitfenster den Modellwert durch Ausführen des Simulationsmodells mit Eingangsdaten, die von ersten Sensordaten des dem jeweiligen Zeitfenster zugeordneten Messdatensatzes bestimmt sind, und Modellparametern, die für das jeweilige Zeitfenster von den jeweils zuletzt ermittelten Optimierungsparametern bestimmt sind, zu ermitteln.

2. Vorrichtung (2) nach dem vorhergehenden Anspruch, **dadurch gekennzeichnet, dass** die von dem Modellwert abgebildete Temperatur des Leistungstransformators (10) eine Hot-Spot-Temperatur oder eine Top-Oil-Temperatur oder eine Bottom-Oil-Temperatur des Leistungstransformators (10) umfasst oder ist.

3. Vorrichtung (2) nach einem der vorhergehenden Ansprüche, **dadurch gekennzeichnet, dass** die Anzahl der gruppenweisen Wiederholung der Gruppe (12) der Schritte a) bis c) zwischen 10 und 1000 ist.

4. Vorrichtung (2) nach einem der vorhergehenden Ansprüche, **dadurch gekennzeichnet, dass** die Vorrichtung (2) konfiguriert ist, den Zielwert in Schritt b) ab der Ausführung für das zweite Zeitfenster jeweils derart zu ermitteln, sodass der Zielwert außerdem eine mit einem zweiten Gewichtungsfaktor gewichtete, quadratische Differenz zwischen den zuletzt bestimmten Modellparametern und den als letztes für das vorherige Zeitfenster ermittelten Optimierungsparametern umfasst.

5. Vorrichtung (2) nach einem der vorhergehenden Ansprüche, **dadurch gekennzeichnet, dass** die Vorrichtung (2) konfiguriert ist, den Zielwert in Schritt b) derart zu ermitteln, sodass der Zielwert außerdem eine mit einem dritten Gewichtungsfaktor gewichtete, quadratische Differenz zwischen den zuletzt bestimmten Modellparametern und Referenzparametern umfasst.

6. Vorrichtung (2) nach einem der vorhergehenden Ansprüche, **dadurch gekennzeichnet, dass** die ersten Sensordaten von außen auf den Leistungstransformator (10) wirkende und sensorisch erfasste Größen repräsentieren.

7. Vorrichtung (2) nach einem der vorhergehenden Ansprüche, **dadurch gekennzeichnet, dass** die ersten Sensordaten mindestens zwei Größen der folgenden Gruppe (12) von Größen repräsentieren: elektrischer Strom an der Primärseite des Leistungstransformators (10), elektrischer Strom an der Sekundärseite des Leistungstransformators (10), elektrische Leistung an der Primärseite des Leistungstransformators (10), elektrische Leistung an der Sekundärseite des Leistungstransformators (10), Umgebungstemperatur (14) an der Außenseite des Leistungstransformators (10), Sonnenstrahlungsleistung an der Außenseite des Leistungstransformators (10) und Windgeschwindigkeit an der Außenseite des Leistungstransformtors (10).

8. Vorrichtung (2) nach einem der vorhergehenden Ansprüche, **dadurch gekennzeichnet, dass** die zweiten Sensordaten im Inneren des Leistungstransformators (10) sensorisch erfasste Größen repräsentieren.

9. Vorrichtung (2) nach einem der vorhergehenden Ansprüche, **dadurch gekennzeichnet, dass** die zweiten Sensordaten mindestens eine Größe der folgenden Gruppe (12) von Größen repräsentieren: Öltemperatur, Öltemperatur an der Oberseite des Leistungstransformators (10), Öltemperatur an der Unterseite des Leistungstransformators (10), Windungstemperatur an Windungen der Primärseite, Windungstemperatur an Windungen der Sekundärseite, Wärmestrom von Windungen der Primärseite des Leistungstransformators (10) ins Öl des Leistungstransformators (10), Wärmestrom von Windungen der Sekundärseite des Leistungstransformators (10) ins Öl des Leistungstransformators (10), und Ölviskosität des Öls des Leistungstransformators (10).

10. Vorrichtung (2) nach einem der vorhergehenden Ansprüche, **dadurch gekennzeichnet, dass** die ersten und zweiten Sensordaten eines Messdatensatzes jeweils die zugehörigen Größen als eine Folge von periodisch und sensorisch erfassten Abtastwerten der Größen repräsentiert.

11. Vorrichtung (2) nach einem der vorhergehenden Ansprüche, **dadurch gekennzeichnet, dass** die Vorrichtung (2) konfiguriert ist, sodass in jedem Zeitfenster ein zugehöriger Messdatensatz aus ersten und zweiten Sensordaten erzeugt wird, die die zugehörigen Größen über einen vorbestimmten Zeitraum repräsentieren.

12. Vorrichtung (2) nach dem vorhergehenden Anspruch, **dadurch gekennzeichnet, dass** der vorbestimmte Zeitraum größer als die größte Zeitkonstante des Leistungstransformators (10) ist.

13. Vorrichtung (2) nach einem der vorhergehenden Ansprüche 11 und 12, **dadurch gekennzeichnet, dass** der vorbestimmte Zeitraum mindestens zwei Stunden, mindestens vier Stunden, mindestens acht Stunden, mindestens sechszehn Stunden, mindestens vierundzwanzig Stunden, oder mindestens zwei Tage beträgt.

14. Vorrichtung (2) nach einem der vorhergehenden Ansprüche, **dadurch gekennzeichnet, dass** das Simulationsmodell basierend auf einem IEEE Annex G-Modell für den Leistungstransformator (10) ausgebildet ist.

15. Vorrichtung (2) nach einem der vorhergehenden Ansprüche 1 bis 13, **dadurch gekennzeichnet, dass** das Simulationsmodell basierend auf einem IEC-Modell basierend auf dem Standard IEC 60076-7 Edition 2.0 2018-01 für den Leistungstransformator (10) ausgebildet ist.

16. Vorrichtung (2) nach einem der vorhergehenden Ansprüche, **dadurch gekennzeichnet, dass** die Vorrichtung (2) ausgebildet ist, ein Ausgangssignal, das den Modellwert repräsentiert, mittels der Signalschnittstelle (4) oder einer anderen Schnittstelle (34) zu übertragen.

17. Vorrichtung (2) nach einem der vorhergehenden Ansprüche, **dadurch gekennzeichnet, dass** die Prozessoreinheit (6) konfiguriert ist, die jeweils zuletzt für ein Zeitfenster ermittelten Optimierungsparametern als Abschlussparameter für das jeweilige Zeitfenster zu bestimmen, Trendparameter durch Approximation mit der Mehrzahl der Abschlussparameter zu ermitteln, die Trendparameter mit zugehörigen, vorbestimmten Grenzwerten zu vergleichen, und bei einem Überschreiten von einem der Grenzwerte einen ersten Warnzustand für den Leistungstransformator (10) zu bestimmen.

18. **System (1),** aufweisend:

eine Mehrzahl von Vorrichtungen (2), die jeweils gemäß der Vorrichtung (2) nach einem der vorhergehenden Ansprüche ausgebildet sind,
wobei das System (1) ausgebildet ist, die von den Vorrichtungen (2) jeweils bestimmten Modellparameter untereinander zu vergleichen und dadurch jeweils Modellparameterdifferenzen zu bestimmen, und
wobei das System (1) ausgebildet ist, die Modellparameterdifferenzen jeweils mit zugehörigen, vorbestimmten Grenzwerten zu vergleichen, und bei einem Überschreiten von einem der Grenzwerte die Modellparameter, die die Überschreitung verursachen, und den zugehörigen Leistungstransformator (10) zu identifizieren, und für den identifizierten Leistungstransformator (10) einen zweiten Warnzustand zu bestimmen.


**Claims**

1. A **device (2),** having:

a signal interface (4),
a processor unit (6), and
a memory unit (8),
wherein the signal interface (4) is designed to receive a measurement signal representing the first sensor data and second sensor data,
wherein the first sensor data and the second sensor data in each case represent at least one quantity detected in or at the power transformer (10) by means of sensors,

wherein the processor unit (6) is configured to produce in each of successive time windows a measurement dataset from the first and second sensor data received in the given time window,

wherein in the memory unit (8) is stored a simulation model of the power transformer (10), which simulation model describes a transfer behavior for input data into output data as a function of model parameters of the simulation model,

wherein the processor unit (6) is configured to execute for each time window the following group (12) of steps a) to c) repeatedly as a group:

a) determining output data by executing the simulation model using input data, which is defined by first sensor data from the measurement dataset assigned to the given time window, and using model parameters, which, for the first execution of the simulation model for the given time window are defined by predefined reference parameters, and otherwise by the most recently determined optimization parameters,
b) determining a target value, which comprises at least one squared error, weighted by a first weighting factor, which error is between the second sensor data from the measurement dataset assigned to the given time window and the previously determined output data, and
c) determining optimization parameters as new model parameters for the simulation model on the basis of the at least one target value determined in the given time window,

wherein the simulation model also describes a model value for a temperature inside the power transformer (10) as a function of input data and model parameters, and

wherein the processor unit (6) is configured to determine for each time window the model value by executing the simulation model using input data, which is defined by first sensor data from the measurement dataset assigned to the given time window, and using model parameters, which for the given time window are defined by the most recently determined optimization parameters.

2. The device (2) as claimed in the preceding claim, **characterized in that** the temperature of the power transformer (10), which temperature is described by the model value, comprises, or is, a hot-spot temperature or a top-oil temperature or a bottom-oil temperature of the power transformer (10).

3. The device (2) as claimed in one of the preceding claims, **characterized in that** the number of repetitions as a group of the group (12) of steps a) to c) is between 10 and 1000.

4. The device (2) as claimed in one of the preceding claims, **characterized in that** the device (2) is configured to determine the target value in step b), for the execution for the second time window onwards, in each case in such a way that the target value additionally comprises a squared difference, weighted by a second weighting factor, which difference is between the most recently determined model parameters and the optimization parameters determined last for the preceding time window.

5. The device (2) as claimed in one of the preceding claims, **characterized in that** the device (2) is configured to determine the target value in step b) in such a way that the target value additionally comprises a squared difference, weighted by a third weighting factor, which difference is between the most recently defined model parameters and reference parameters.

6. The device (2) as claimed in one of the preceding claims, **characterized in that** the first sensor data represents quantities acting on the power transformer (10) from the outside and detected by means of sensors.

7. The device (2) as claimed in one of the preceding claims, **characterized in that** the first sensor data represents at least two quantities from the following group (12) of quantities: electric current on the primary side of the power transformer (10), electric current on the secondary side of the power transformer (10), electrical power on the primary side of the power transformer (10), electrical power on the secondary side of the power transformer (10), ambient temperature (14) outside the power transformer (10), solar radiation power outside the power transformer (10), and wind speed outside the power transformer (10).

8. The device (2) as claimed in one of the preceding claims, **characterized in that** the second sensor data represents quantities detected inside the power transformer (10) by means of sensors.

9. The device (2) as claimed in one of the preceding claims, **characterized in that** the second sensor data represents at least one quantity from the following group (12) of quantities: oil temperature, oil temperature at the top of the power transformer (10), oil temperature at the bottom of the power transformer (10), winding temperature at primary-side windings, winding temperature at secondary-side windings, heat flow from primary-side windings of the power transformer (10) into the oil of the power transformer (10), heat flow from secondary-side windings of the power transformer (10) into the oil of the power transformer (10), and oil viscosity of the oil of the power transformer (10).

10. The device (2) as claimed in one of the preceding claims, **characterized in that** the first and second sensor data from a measurement dataset represent in each case the associated quantities resulting from sample values of the quantities detected at periodic intervals by means of sensors.

11. The device (2) as claimed in one of the preceding claims, **characterized in that** the device (2) is configured so that in each time window, an associated measurement dataset is produced from first and second sensor data that represent the associated quantities over a predefined time span.

12. The device (2) as claimed in one of the preceding claims, **characterized in that** the predefined time span is greater than the largest time constant of the power transformer (10).

13. The device (2) as claimed in one of preceding claims 11 and 12, **characterized in that** the predefined time span equals at least two hours, at least four hours, at least eight hours, at least sixteen hours, at least twenty-four hours, or at least two days.

14. The device (2) as claimed in one of the preceding claims, **characterized in that** the simulation model is based on an IEEE Annex G model for the power transformer (10).

15. The device (2) as claimed in one of preceding claims 1 to 13 **characterized in that** the simulation model is based on an IEC model based on the Standard IEC 600076-7 Edition 2.0 2018-01 for the power transformer (10).

16. The device (2) as claimed in one of the preceding claims, **characterized in that** the device (2) is designed to transfer by means of the signal interface (4) or another interface (34), an output signal representing the model value.

17. The device (2) as claimed in one of the preceding claims, **characterized in that** the processor unit (6) is configured to define the optimization parameters most recently determined for a time window as final parameters for the given time window, to determine trend parameters by an approximation using the plurality of final parameters, to compare the trend parameters with associated predefined limit values, and, in the event that one of the limit values is exceeded, to define a first warning state for the power transformer (10).

18. A **system (1),** having:

a plurality of devices (2), each designed according to the device (2) as claimed in one of the preceding claims, wherein the system (1) is designed to compare with each other the model parameters defined by each of the devices (2), and thereby ascertain model-parameter differences in each case, and
wherein the system (1) is designed to compare each of the model-parameter differences with associated predefined limit values, and in the event that one of the limit values is exceeded, to identify the model parameters causing said exceeding, and the associated power transformer (10), and to define for the identified power transformer (10) a second warning state.

**Revendications**

1. Dispositif (2), présentant :

une interface de signal (4),
une unité de processeur (6), et
une unité de mémoire (8),
dans lequel l'interface de signal (4) est réalisée pour recevoir un signal de mesure qui représente des premières données de capteur et des deuxièmes données de capteur,
dans lequel les premières et deuxièmes données de capteur représentent respectivement au moins une grandeur détectée par des capteurs dans ou sur un transformateur de puissance (10),
dans lequel l'unité de processeur (6) est configurée pour générer dans des fenêtres de temps successives respectivement un jeu de données de mesure à partir des premières et deuxièmes données de capteur reçues dans la fenêtre temporelle respective,

dans lequel dans l'unité de mémoire (8) est stocké un modèle de simulation du transformateur de puissance (10) qui reproduit un comportement de transmission de données d'entrée en données de sortie en fonction de paramètres de modèle du modèle de simulation,

dans lequel l'unité de processeur (6) est configurée pour exécuter pour chaque fenêtre temporelle le groupe suivant (12) d'étapes a) à c) par groupes de manière répétée :

a) l'identification de données de sortie par l'exécution du modèle de simulation avec des données d'entrée qui sont déterminées à partir des premières données de capteur du jeu de données de mesure associé à la fenêtre temporelle respective, et de paramètres de modèle qui sont déterminés à la première exécution du modèle de simulation pour la fenêtre temporelle respective à partir de paramètres de référence prédéterminés et sont sinon déterminés à partir des paramètres d'optimisation respectivement identifiés en dernier,

b) l'identification d'une valeur cible qui comprend au moins une erreur quadratique, pondérée par un premier facteur de pondération, entre les deuxièmes données de capteur du jeu de données de mesure associé à la fenêtre temporelle respective et les données de sortie identifiées précédemment, et

c) l'identification de paramètres d'optimisation en tant que nouveaux paramètres de modèle pour le modèle de simulation sur la base de ladite au moins une valeur cible identifiée dans la fenêtre temporelle respective,

dans lequel le modèle de simulation reproduit en outre une valeur de modèle pour une température à l'intérieur du transformateur de puissance (10) en fonction de données d'entrée et de paramètres de modèle, et

dans lequel l'unité de processeur (6) est configurée pour identifier pour chaque fenêtre temporelle la valeur de modèle par l'exécution du modèle de simulation avec des données d'entrée qui sont déterminées à partir de premières données de capteur du jeu de données de mesure associé à la fenêtre temporelle respective, et de paramètres de modèle qui sont déterminés pour la fenêtre temporelle respective à partir des paramètres d'optimisation identifiés respectivement en dernier.

2. Dispositif (2) selon la revendication précédente, **caractérisé en ce que** la température du transformateur de puissance (10), reproduite par la valeur de modèle, comprend ou est une température de point chaud ou une température de couche d'huile supérieure ou une température de couche d'huile supérieure du transformateur de puissance (10).

3. Dispositif (2) selon l'une quelconque des revendications précédentes, **caractérisé en ce que** le nombre de répétitions par groupes du groupe (12) des étapes a) à c) est compris entre 10 et 1000.

4. Dispositif (2) selon l'une quelconque des revendications précédentes, **caractérisé en ce que** le dispositif (2) est configuré pour identifier la valeur cible à l'étape b) à partir de l'exécution pour la deuxième fenêtre temporelle respectivement de telle sorte que la valeur cible comprend en outre une différence quadratique, pondérée par un deuxième facteur de pondération, entre les paramètres de modèle déterminés en dernier et les paramètres d'optimisation identifiés en dernier pour la fenêtre temporelle précédente.

5. Dispositif (2) selon l'une quelconque des revendications précédentes, **caractérisé en ce que** le dispositif (2) est configuré pour identifier la valeur cible à l'étape b) de telle sorte que la valeur cible comprend en outre une différence quadratique, pondérée par un troisième facteur de pondération, entre les paramètres de modèle et paramètres de référence déterminés en dernier.

6. Dispositif (2) selon l'une quelconque des revendications précédentes, **caractérisé en ce que** les premières données de capteur représentent des grandeurs agissant depuis l'extérieur sur le transformateur de puissance (10) et détectées par des capteurs.

7. Dispositif (2) selon l'une quelconque des revendications précédentes, **caractérisé en ce que** les premières données de capteur représentent au moins deux grandeurs du groupe suivant (12) de grandeurs : le courant électrique sur le côté primaire du transformateur de puissance (10), le courant électrique sur le côté secondaire du transformateur de puissance (10), la puissance électrique sur le côté primaire du transformateur de puissance (10), la puissance électrique sur le côté secondaire du transformateur de puissance (10), la température ambiante (14) sur le côté extérieur du transformateur de puissance (10), la puissance de rayonnement solaire sur le côté extérieur du transformateur de puissance (10) et la vitesse du vent sur le côté extérieur du transformateur de puissance (10).

8. Dispositif (2) selon l'une quelconque des revendications précédentes, **caractérisé en ce que** les deuxièmes données de capteur à l'intérieur du transformateur de puissance (10) représentent des grandeurs détectées par des capteurs.

9. Dispositif (2) selon l'une quelconque des revendications précédentes, **caractérisé en ce que** les deuxièmes données de capteur représentent au moins une grandeur du groupe suivant (12) de grandeurs : la température d'huile, la température d'huile sur la face supérieure du transformateur de puissance (10), la température d'huile sur la face inférieure du transformateur de puissance (10), la température d'enroulement au niveau des enroulements du côté primaire, la température d'enroulement au niveau des enroulements du côté secondaire, le flux thermique des enroulements sur le côté primaire du transformateur de puissance (10) dans l'huile du transformateur de puissance (10), le flux thermique des enroulements du côté secondaire du transformateur de puissance (10) dans l'huile du transformateur de puissance (10), et la viscosité d'huile de l'huile du transformateur de puissance (10).

10. Dispositif (2) selon l'une quelconque des revendications précédentes, **caractérisé en ce que** les premières et deuxièmes données de capteur d'un jeu de données de mesure représentent respectivement les grandeurs associées sous la forme d'une séquence de valeurs de balayage des grandeurs, détectées périodiquement et par des capteurs.

11. Dispositif (2) selon l'une quelconque des revendications précédentes, **caractérisé en ce que** le dispositif (2) est configuré de sorte qu'un jeu de données de mesure associé est généré dans chaque fenêtre temporelle à partir de premières et deuxièmes données de capteur qui représentent les grandeurs associées pendant une période de temps prédéterminée.

12. Dispositif (2) selon la revendication précédente, **caractérisé en ce que** la période de temps prédéterminée est supérieure à la plus grande constante de temps du transformateur de puissance (10).

13. Dispositif (2) selon l'une quelconque des revendications précédentes 11 et 12, **caractérisé en ce que** la période de temps prédéterminée correspond à au moins deux heures, au moins quatre heures, au moins huit heures, au moins seize heures, au moins vingt-quatre heures ou au moins deux jours.

14. Dispositif (2) selon l'une quelconque des revendications précédentes, **caractérisé en ce que** le modèle de simulation est réalisé sur la base d'un modèle IEEE Annexe G pour le transformateur de puissance (10).

15. Dispositif (2) selon l'une quelconque des revendications précédentes 1 à 13, **caractérisé en ce que** le modèle de simulation est réalisé sur la base d'un modèle IEC basé sur la norme IEC 60076-7 édition 2.0 2018-01 pour le transformateur de puissance (10).

16. Dispositif (2) selon l'une quelconque des revendications précédentes, **caractérisé en ce que** le dispositif (2) est réalisé pour transmettre un signal de sortie qui représente la valeur de modèle au moyen de l'interface de signal (4) ou d'une autre interface (34) .

17. Dispositif (2) selon l'une quelconque des revendications précédentes, **caractérisé en ce que** l'unité de processeur (6) est configurée pour déterminer les paramètres d'optimisation identifiés respectivement en dernier pour une fenêtre temporelle en tant que paramètres finaux pour la fenêtre temporelle respective, pour identifier des paramètres de tendance par approximation avec la pluralité des paramètres finaux, pour comparer les paramètres de tendance avec des valeurs limites prédéterminées associées, et pour déterminer un premier état d'alerte pour le transformateur de puissance (10) en cas de dépassement d'une des valeurs limites.

18. Système (1), présentant :

   une pluralité de dispositifs (2) qui sont réalisés respectivement selon le dispositif (2) selon l'une quelconque des revendications précédentes,
   dans lequel le système (1) est réalisé pour comparer entre eux les paramètres de modèle respectivement déterminés par les dispositifs (2) et pour déterminer ainsi respectivement des différences de paramètre de modèle, et
   dans lequel le système (1) est réalisé pour comparer les différences de paramètres de modèle respectivement avec des valeurs limites prédéterminées associées, et en cas de dépassement d'une des valeurs limites, pour identifier les paramètres de modèle qui provoquent le dépassement, et le transformateur de puissance (10) associé, et pour déterminer un deuxième état d'alerte pour le transformateur de puissance (10) identifié.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2015027127 A1

- CN 106844972 A